(19) Europäisches Patentamt
European Patent Office
Office européen des brevets

(11) EP 3 861 574 B1

(12) # EUROPEAN PATENT SPECIFICATION

(45) Date of publication and mention of the grant of the patent:
**06.05.2026 Bulletin 2026/19**

(21) Application number: **19906952.7**

(22) Date of filing: **02.10.2019**

(51) International Patent Classification (IPC):
***H10N 60/01*** (2023.01) ***G21B 1/11*** (2006.01)
***G21F 3/00*** (2006.01) *G21F 1/10* (2006.01)
*G21F 1/12* (2006.01) *H01F 6/06* (2006.01)

(52) Cooperative Patent Classification (CPC):
**G21B 1/11; G21F 3/00; H10N 60/0828; H10N 60/0884;** G21F 1/10; G21F 1/125; H01F 6/06; Y02E 30/10

(86) International application number:
**PCT/US2019/054211**

(87) International publication number:
**WO 2020/142119 (09.07.2020 Gazette 2020/28)**

(54) **TECHNIQUES FOR CRYOGENIC RADIATION ENHANCEMENT OF SUPERCONDUCTORS AND RELATED SYSTEMS AND METHODS**

VERFAHREN ZUR TIEFTEMPERATUR-STRAHLUNGSVERBESSERUNG VON SUPRALEITERN SOWIE VERWANDTE SYSTEME UND VERFAHREN

TECHNIQUES D'AMÉLIORATION DE RAYONNEMENT CRYOGÉNIQUE DE SUPRACONDUCTEURS AINSI QUE SYSTÈMES ET PROCÉDÉS ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.10.2018 US 201862740163 P**
**18.06.2019 US 201916444467**

(43) Date of publication of application:
**11.08.2021 Bulletin 2021/32**

(73) Proprietor: **MASSACHUSETTS INSTITUTE OF TECHNOLOGY**
**Cambridge, MA 02139 (US)**

(72) Inventors:
- **SORBOM, Brandon, Nils**
  **Cambridge, Massachusetts 02138 (US)**
- **HARTWIG, Zachary**
  **Jamaica Plain, Massachusetts 02130 (US)**
- **WHYTE, Dennis G.**
  **Brookline, Massachusetts 02446 (US)**

(74) Representative: **Murgitroyd & Company**
**165-169 Scotland Street**
**Glasgow G5 8PL (GB)**

(56) References cited:
**US-A- 5 096 882**
**US-A1- 2015 263 259**
**US-A1- 2018 047 461**
**US-B1- 6 525 002**

- **PROKOPEC R ET AL: "Suitability of coated conductors for fusion magnets in view of their radiation response", SUPERCONDUCTOR SCIENCE AND TECHNOLOGY, IOP PUBLISHING, TECHNO HOUSE, BRISTOL, GB, vol. 28, no. 1, 9 December 2014 (2014-12-09), pages 14005, XP020276280, ISSN: 0953-2048, [retrieved on 20141209], DOI: 10.1088/0953-2048/28/1/014005**
- **TORU AOKI ET AL: "Effect of Neutron Irradiation on High-Temperature Superconductors", IEEE TRANSACTIONS ON APPLIED SUPERCONDUCTIVITY, IEEE, USA, vol. 21, no. 3, 1 June 2011 (2011-06-01), pages 3200 - 3202, XP011325434, ISSN: 1051-8223, DOI: 10.1109/TASC.2010.2101999**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 861 574 B1

- MENARD J E ET AL: "Fusion nuclear science facilities and pilot plants based on the spherical tokamak", NUCLEAR FUSION, PUBLISHING SECTION. VIENNA, AT, vol. 56, no. 10, 16 August 2016 (2016-08-16), pages 106023, XP020308750, ISSN: 0029-5515, [retrieved on 20160816], DOI: 10.1088/0029-5515/56/10/106023
- THE DEMO PLANT DESIGN TEAM ET AL: "Neutronics assessment of advanced shield materials using metal hydride and borohydride for fusion reactors", FUSION ENGINEERING AND DESIGN, ELSEVIER SCIENCE PUBLISHERS, AMSTERDAM, NL, vol. 81, no. 8-14, 1 February 2006 (2006-02-01), pages 1285 - 1290, XP027974609, ISSN: 0920-3796, [retrieved on 20060201]
- CHUYANOV V A ET AL: "Modular fusion power plant", FUSION ENGINEERING AND DESIGN, ELSEVIER SCIENCE PUBLISHERS, AMSTERDAM, NL, vol. 122, 4 September 2017 (2017-09-04), pages 238 - 252, XP085301350, ISSN: 0920-3796, DOI: 10.1016/ J.FUSENGDES.2017.07.017
- BEHERA D ET AL: "Irradiation-induced inter- and intra-granular modifications by 120 MeV S ions in YBa2Cu3O7 thick films", MODERN PHYSICS LETTERS B: CONDENSED MATTER PHYSICS; STATISTICAL PHYSICS AND APPLIED PHYSICS, WORLD SCIENTIFIC PUBLISHING CO. PTE. LTD, SG, vol. 15, no. 2, 30 January 2001 (2001-01-30), pages 69 - 80, XP009536813, ISSN: 0217-9849, [retrieved on 20200709], DOI: 10.1142/ S0217984901001483
- BOURGAULT D ET AL: "Modifications of the physical properties of the high-Tc superconductors YBa2Cu3O7-delta (0.1 <= delta <= 0.7) by 3.5-GeV xenon ion bombardment", PHYSICAL REVIEW B, vol. 39, no. 10, 1 April 1989 (1989-04-01), pages 6549 - 6554, XP055934189, Retrieved from the Internet <URL:https:// journals.aps.org/prb/pdf/10.1103/ PhysRevB.39.6549> DOI: 10.1103/ physrevb.39.6549
- NISHIMURA A, TAKEUCHI T, NISHIJIMA S, OCHIAI K, NISHIJIMA G, WATANABE K, SHIKAMA T: "4 MEV NEUTRON IRRADIATION EFFECT ON CRITICAL CURRENT AND CRITCAL MAGNETIC FIELD OF AND WIRES ARTICLES YOU MAY BE INTERESTED IN Fast neutron irradiation effect on superconducting properties of Nb 3 Sn and Nb 3 Al strands", AIP CONFERENCE PROCEEDINGS AIP CONFERENCE PROCEEDINGS, 1 January 2010 (2010-01-01), pages 255 - 262, XP055934212, Retrieved from the Internet <URL:https://aip. scitation.org/doi/pdf/10.1063/1.3402309> [retrieved on 20220622]
- YOSHIDA: "Low-temperature neutron irradiation tests of superconducting magnet materials using reactor neutrons at KUR ARTICLES YOU MAY BE INTERESTED IN Fast neutron irradiation effect on superconducting properties of Nb 3 Sn and Nb 3 Al strands", AIP CONFERENCE PROCEEDINGS AIP CONFERENCE PROCEEDINGS, 1 January 2012 (2012-01-01), pages 167 - 173, XP055934228, Retrieved from the Internet <URL:https://aip.scitation.org/doi/ pdf/10.1063/1.4712093> [retrieved on 20220622]
- ANDO T ET AL: "Design of the TF Coil for a Tokamak Fusion Power Reactor with YBCO Tape Superconductors", FUSION ENGINEERING 2005, TWENTY-FIRST IEEE/NPS SYMPOSIUM ON, IEEE, PI, 1 September 2005 (2005-09-01), pages 1 - 4, XP031020903, ISBN: 978-0-424-40159-1, DOI: 10.1109/FUSION.2005.252876
- PERKINS ET AL.: "Effects of proton irradiation and ageing on the superconducting properties of single crystalline and polycrystalline MgB2", SUPERCONDUCTOR SCIENCE AND TECHNOLOGY, vol. 17, no. 1, 9 December 2003 (2003-12-09), XP020051619

## Description

BACKGROUND

Superconductors are materials that have no electrical resistance to current (are "superconducting") below some critical temperature. For many superconductors, the critical temperature is below 30 K, such that operation of these materials in a superconducting state requires significant cooling, such as with liquid helium.

High temperature superconductors ("HTS") are a class of superconductors that have a comparatively high critical temperature, such as between 50 K - 100 K. Some HTS materials, such as rare-earth barium copper oxide ("REBCO"), can be produced as long strands, leading to the possibility of using these materials to wind large bore magnets for use in fusion devices, among other applications.

BEHERA D ET AL: "Irradiation-induced inter- and intra-granular modifications by 120 MeV S ions in YBa2Cu3O7 thick films", MODERN PHYSICS LETTERS B: CONDENSED MATTER PHYSICS; STATISTICAL PHYSICS AND APPLIED PHYSICS, WORLD SCIENTIFIC PUBLISHING CO. PTE. LTD, SG, vol. 15, no. 2, 30 January 2001 (2001-01-30), pages 69-80, XP009536813, discloses a method for inducing granular modification in YBCO thick films comprising producing YBCO thick films through diffusion reaction technique and irradiating the thick films with 120 MeV S ion irradiation. PROKOPEC R ET AL., "Suitability of coated conductors for fusion magnets in view of their radiation response", SUPERCONDUCTOR SCIENCE AND TECHNOLOGY, vol. 28, 014005, p. 1-8, (2015), XP020276280, and TORU AOKI ET AL., "Effect of Neutron Irradiation on High-Temperature Superconductors", IEEE TRANSACTIONS ON SUPERCONDUCTIVITY, vol. 21, no. 3, p. 3200-3202, (2011), XP011325434, disclose neutron irradiation of HTS tape. There is no disclosure of the neutron irradiation of an HTS tape being carried out at a cryogenic temperature between 10 K and 80 K.

SUMMARY

According to the present invention, there is provided a method according to claim 1. Advantageous features are provided in the dependent claims. The tape according to the invention irradiated with neutrons at a cryogenic temperature according to claim 1 chosen to effectively eliminate widening of boundaries of crystalline grains of the superconductor can be used in a field coil of a nuclear fusion reactor.

BRIEF DESCRIPTION OF DRAWINGS

Various aspects and embodiments will be described with reference to the following figures. It should be appreciated that the figures are not necessarily drawn to scale. In the drawings, each identical or nearly identical component that is illustrated in various figures is represented by a like numeral. For purposes of clarity, not every component may be labeled in every drawing.

FIG. 1 shows an illustrative crystal structure for a rare-earth barium copper oxide ("REBCO") compound;
FIG. 2 shows a cross-section of the layers of an illustrative coated-conductor REBCO tape;
FIG. 3 is a plot of normalized critical temperature *(Tc)* dependence on hole concentration for a wide variety of cuprate superconductors;
FIG. 4 shows a TEM image of an illustrative YBCO superconductor;
FIG. 5 shows a superconducting material and illustrates the difference between strong and weak pinning sites;
FIG. 5A comprises two plots of (top) free energy density contributions from electron ordering and magnetization, and (bottom) their sum, showing that the normal-superconducting boundary is thermodynamically stable, allowing some flux penetration;
FIG. 6 is a plot of critical current density *Jc,* at 5 T and 30 K, of samples irradiated at different temperatures to fluences of $1\times10^{16}$ p/cm$^2$ and $5\times10^{16}$ p/cm$^2$;
FIG. 7 is a selection of plots illustrating irradiation temperature effect on REBCO *Jc* degradation due to proton irradiation at various measurement fields and temperatures;
FIG. 8 is a plot of critical temperature of an irradiated superconductor versus the irradiation temperature;
FIG. 9 compares measured critical current density *Jc* with a fit to the predicted dependence on weak pinning;
FIG. 10A compares of *Jc* with measurement angle $\theta$ at low temperature, low fluence irradiation (80 K and $5\times10^{15}$ p/cm$^2$);
FIG. 10B compares *Jc* with $\theta$ at low temperature, medium fluence irradiation (80 K and $1\times10^{16}$ p/cm$^2$);
FIG. 10C compares *Jc* with $\theta$ at low temperature, high fluence irradiation (80 K and $5\times10^{16}$ p/cm$^2$);
FIG. 10D compares *Jc* with $\theta$ at high temperature, low fluence irradiation (423 K and $5\times10^{15}$ p/cm$^2$);
FIG. 10E compares *Jc* with $\theta$ at high temperature, medium fluence irradiation (423 K and $1\times10^{16}$ p/cm$^2$);
FIG. 10F compares *Jc* with $\theta$ at high temperature, high fluence irradiation (423 K and $5\times10^{16}$ p/cm$^2$);

FIG. 11A compares *Jc* with magnetic field strength B for an unirradiated control sample fitted to a power law;
FIG. 11B compares *Jc* with B for a superconductor irradiated at 80 K to medium and high fluences, with calculated fits to a power law at each fluence;
FIG. 11C compares *Jc* with B for a superconductor irradiated at 423 K to medium and high fluences, with calculated fits to a power law at each fluence;
FIG. 12A is a plot of pinning limited *Jc* for irradiation at 80 K to a low fluence of $1\times10^{15}$ p/cm$^2$;
FIG. 12B is a plot of pinning limited *Jc* for irradiation at 80 K to a low fluence of $5\times10^{15}$ p/cm$^2$;
FIG. 12C is a plot showing crossover between grain-boundary limited and pinning limited *Jc* regimes for irradiation at 80 K to a moderate fluence of $1\times10^{16}$ p/cm$^2$;
FIG. 12D is a plot showing crossover between grain-boundary limited and pinning limited *Jc* regimes for irradiation at 80 K to a high fluence of $5\times10^{16}$ p/cm$^2$;
FIG. 13 compares *Jc* regimes for 80 K and 423 K irradiation to the high fluence;
FIG. 14 is a plot of simulated Frenkel pair production per primary knock-on atom (PKA) vs. PKA energy for irradiations at 80 K and 423 K;
FIG. 15 compares cumulative distribution of PKA energy functions resulting from 1 MeV protons and neutrons according to a compact fusion model (denoted "ARC");
FIG. 16 is a plot of a mean-square-distribution ("MSD") fit to determine a diffusion coefficient in a simulated YBCO lattice at 800 K;
FIG. 17 is a flowchart for an illustrative process for manufacturing a REBCO tape according to an embodiment;
FIG. 18A depicts a target mount for irradiating an HTS, showing a first collimator at top, then an electron suppression electrode, then a secondary G-10 collimator mount at bottom;
FIG. 18B is a close-up of the target area with the collimator and suppression electrode removed, showing the current pickups used to center the beam on target during operation;
FIG. 19 is a schematic depicting irradiation of a polycrystalline superconductor with neutrons and optionally ions, according to some embodiments;
FIG. 20A is a schematic illustrating a cross-section of a fusion reactor, according to some embodiments; and
FIG. 20B is a three-dimensional graphic of a fusion reactor with a cutaway portion illustrating various components of the reactor, according to some embodiments.

## DETAILED DESCRIPTION

As discussed above, some high temperature superconductor (HTS) materials can be produced as long strands and wound (along with other materials) to form magnets. These magnets may be deployed in a wide variety of different devices, including nuclear magnetic resonance (NMR) devices, magnetic resonance imaging (MRI) devices, electrical power generators (e.g., wind turbines), medical accelerators (e.g., proton therapy systems), superconducting energy storage devices, nuclear fusion reactors (e.g., tokomaks), magnetohydrodynamic (MHD) electrical generators, etc.

For some applications, HTS materials may be produced as a long, thin strand, often referred to as a "tape." The HTS material in a tape is typically polycrystalline due to its length and the techniques by which the tape is produced. In a polycrystalline material, the interfaces between crystallites, known as "grain boundaries," may, however, interfere with the electrical properties of the material. In particular, for superconducting materials, the presence of misaligned grain boundaries may lower the critical current of the material, which is the maximum electrical transport current density that the superconductor can maintain without resistance. As a result, for polycrystalline superconductors it is desirable that there is a high level of alignment between neighboring grains, so that the effect of grain boundaries upon the electrical characteristics of the superconductor may be minimized. As such, HTS tapes are often produced with a high level of grain alignment.

The inventors have recognized and appreciated that the grain boundaries of polycrystalline superconductors may be degraded when exposed to a sufficiently high fluence of neutrons and/or ions. Furthermore, the inventors have recognized and appreciated that the amount of degradation of the grain boundaries may vary as a function of the temperature of the polycrystalline superconductor during irradiation, with lower temperatures producing less degradation. Without wishing to be bound by theory, it is believed that the primary effect caused by incident neutrons and/or ions is to allow defects within the polycrystalline superconductor to diffuse to grain boundaries. As a result of this radiation-enhanced diffusion of defects, the grain boundaries may widen and/or suffer from reduced alignment, leading to the above-described negative effects upon the electrical characteristics of the superconductor.

It may be noted that degradation of grain boundaries is not expected in single-crystal superconductors due to their lack of grain boundaries. In addition, while neutrons and/or ions incident onto sintered polycrystalline superconductors may produce some degradation of grain boundaries, the lack of initial grain alignment in these materials means that degradation of the grain boundaries may not lead to a measurable reduction in the electrical performance of sintered polycrystalline superconductors. In contrast, as recognized and appreciated by the inventors, neutrons and/or ions incident onto long, grain-aligned polycrystalline superconductors may cause significant degradation of the electrical characteristics of the material.

The above-described effects of neutrons and/or ions incident onto polycrystalline superconductors may cause a device comprising the polycrystalline superconductor to function with lower performance over time. For instance, a magnet comprising a polycrystalline superconductor (e.g., a magnet in an MRI system) may, over time, be exposed to radiation that causes degradation of the grain boundaries of the superconductor, leading to a lower critical current of the superconductor, and thereby altering the performance of the magnet.

The inventors have further recognized and appreciated that exposure to incident neutrons and/or ions may form and/or enhance pinning sites in a polycrystalline superconductor, with this effect being more pronounced at cryogenic temperatures (e.g., below 80 Kelvin). Pinning sites are locations within a superconductor at which lines of magnetic flux are held in place. In a Type II superconductor, lines of magnetic flux may experience a Lorentz force due to current passing through the superconductor, but this force may be counteracted by a "pinning" force exerted by the pinning sites. Defects in the superconducting material may, for instance, act as pinning sites. Generally speaking, a greater total pinning force provided by the pinning sites leads to a greater critical current. As a result, exposing a polycrystalline superconductor to incident neutrons and/or ions may improve the electrical characteristics of the superconductor by forming and/or enhancing pinning sites in the superconductor, and may do so to a greater extent when said exposure is performed when the superconductor is at a cryogenic temperature.

The inventors have further recognized and appreciated that degradation of the electrical characteristics of a polycrystalline superconductor during use of the superconductor in a device may be mitigated by exposing the superconductor to neutrons and/or ions at cryogenic temperatures prior to incorporation of the superconductor in the device. As discussed above, the inventors have recognized that the amount of degradation of the grain boundaries of a polycrystalline superconductor exposed to incident neutrons and/or ions is reduced at lower temperatures. Furthermore, exposing the polycrystalline superconductor to the incident neutrons and/or ions at lower temperatures may create and/or enhance pinning sites in the superconductor. The net result of these two effects may be a net improvement in the electrical characteristics of the superconductor, such as an increase in the critical current. In at least some cases, degradation of the grain boundaries of the superconductor may subsequently still occur as discussed above, but the prior "treatment" of the superconductor to improve its electrical characteristics may partially or fully negate the degradation due to degradation of grain boundaries.

For instance, a magnet comprising a polycrystalline superconductor may be exposed to radiation from the environment over a period of time, leading to degradation of the grain boundaries of the polycrystalline superconductor as discussed above. Prior to installation of the polycrystalline superconductor in the magnet, the superconductor may be exposed to incident neutrons and/or ions when the superconductor is at a cryogenic temperature. This creates and/or enhances pinning sites in the superconductor while not significantly degrading the grain boundaries, leading to a net improvement in the superconductor's electrical characteristics. As such, any degradation of the grain boundaries that occurs during operation of the magnet may be offset by the improvements produced by "treating" the superconductor prior to its installation in the magnet.

In some cases, a fusion reactor that includes magnets, such as a tokomak, may incorporate a polycrystalline superconductor into the magnets. In such cases, the polycrystalline superconductor may be exposed to neutrons produced within the reactor, and which have trajectories unaffected by the magnets. Generally, shielding effective at blocking neutrons is arranged between the reactor core and the superconducting magnets in a reactor to protect the magnets. As a reactor of a given power output is made more compact, it is desirable to reduce the size of the neutron shield in a proportionate manner. However, linear reductions in the shield thickness lead to exponentially higher neutron fluxes, which may present a challenge in making a compact high power reactor with sufficient neutron shielding.

As discussed above, the inventors have recognized and appreciated that degradation of grain boundaries of polycrystalline superconductors may be minimized at cryogenic temperatures, and that exposure to incident neutrons may create and/or enhance pinning sites in a polycrystalline superconductor, with this effect being more pronounced at cryogenic temperatures. Since the polycrystalline superconductors in magnets operating in fusion reactors are held at cryogenic temperatures, the inventors' recognition of these effects indicates that the neutron shield thickness may be smaller than conventionally considered. That is, the inventors' recognition of these effects indicate that the net effect of the incident neutrons on the polycrystalline superconductor may cause limited degradation of the superconductor, and in some cases may even enhance its electrical characteristics. As a result, fusion reactors with less shielding may be fabricated, allowing more compact reactors to be made.

Following below are more detailed descriptions of various concepts related to, and embodiments of, techniques for cryogenic radiation enhancement of superconductors. It should be appreciated that various aspects described herein may be implemented in any of numerous ways. Examples of specific implementations are provided herein for illustrative purposes only. In addition, the various aspects described in the embodiments below may be used alone or in any combination, and are not limited to the combinations explicitly described herein.

FIG. 19 is a schematic depicting irradiation of a polycrystalline superconductor with neutrons and optionally ions, according to some embodiments. In the example of FIG. 19, system 1900 includes a source 1910 of neutrons and optionally ions, which produces neutron and optionally ion beam 1915 that is incident on a portion 1921 of a polycrystalline superconductor 1920. The polycrystalline superconductor 1920, or at least the portion 1921 of the polycrystalline superconductor, may be at a cryogenic temperature, examples of which are described below.

According to the invention, source 1910 comprises a device configured to output neutrons and in examples outside the invention to output ions, such as but not limited to, electrons, protons, alpha particles, etc. In some examples, for instance, the source 1910 may comprise a proton beam source such as a duoplasmatron, a magnetron, and/or a laser configured to direct a laser beam onto a material to produce protons (e.g., a laser beam onto a metal foil). In some examples, the source 1910 may comprise an electron gun. According to the invention, the source 1910 is a source of neutrons, such as a spallation source or a particle accelerator.

Source 1910 may be operated for a length of time so as to produce a fluence of particles incident upon the portion 1921 of the polycrystalline superconductor of between $10^{12}$ particles/cm$^2$ and $10^{16}$ particles/cm$^2$. The fluence is a total number of particles produced over an area. In an embodiment, source 1910 produces a fluence of particles greater than $10^{15}$ particles/cm$^2$. Source 1910 may produce a fluence of particles greater than or equal to $10^{12}$, $10^{13}$, $10^{14}$, $10^{15}$ or $10^{16}$ particles/cm$^2$. Source 1910 may produce a fluence of particles less than or equal to $10^{16}$, $5\times10^{15}$, $10^{14}$, or $10^{13}$ particles/cm$^2$. Any suitable combinations of the above-referenced ranges are also possible (e.g., a fluence between $10^{14}$ and $5\times10^{15}$ particles/cm$^2$). Since the fluence values represent a total number of incident particles, it will be appreciated that the values are independent of the time taken to cause the specified number of particles to be incident upon the portion 1921 of the polycrystalline superconductor. As an illustrative example, source 1910 may produce a flux of particles at the surface of the portion 1921 of the polycrystalline superconductor that is $10^{12}$ particles/cm$^2$/s for 1000 seconds to produce a fluence of $10^{16}$ particles/cm$^2$.

In some examples, source 1910 may be configured to produce a fluence of protons greater than or equal to $10^{15}$, $5\times10^{15}$, $10^{16}$ or $5\times10^{16}$ protons/cm$^2$. In some embodiments, source 1910 may be configured to produce a fluence of protons less than or equal to $10^{17}$, $5\times10^{16}$, $10^{16}$ or $5\times10^{15}$ protons/cm$^2$. Any suitable combinations of the above-referenced ranges are also possible (e.g., a fluence between $5\times10^{15}$ and $10^{16}$ protons/cm$^2$).

In some embodiments, source 1910 may be configured to produce a fluence of neutrons greater than or equal to $10^{17}$, $5\times10^{17}$, $10^{18}$, $5\times10^{18}$, $10^{19}$, or $5\times10^{19}$ neutrons/cm$^2$. In some embodiments, source 1910 may be configured to produce a fluence of neutrons less than or equal to $5\times10^{19}$, $10^{19}$, $5\times10^{18}$, $10^{18}$ or $5\times10^{17}$ neutrons/cm$^2$. Any suitable combinations of the above-referenced ranges are also possible (e.g., a fluence between $5\times10^{17}$ and $10^{18}$ neutrons/cm$^2$).

In some examples, source 1910 may be configured to produce protons with a mean kinetic energy of greater than or equal to 0.5 MeV, 1 MeV, 2 MeV, 5 MeV, or 10 MeV. In some embodiments, source 1910 may be configured to produce protons with a mean kinetic energy of less than or equal to 20 MeV, 15 MeV, 10 MeV, 5 MeV, or 2 MeV. Any suitable combinations of the above-referenced ranges are also possible (e.g., proton kinetic energy between 1 MeV and 2 MeV). In some embodiments, source 1910 may be configured to produce neutrons with a mean kinetic energy of greater than or equal to 0.1 MeV, 0.2 MeV or 0.5 MeV.

According to some embodiments, polycrystalline superconductor 1920 may comprise a rare-earth barium copper-oxide (REBCO) material, an yttrium barium copper-oxide (YBCO) material, any rare-earth cuprate material, or combinations thereof. According to some embodiments, polycrystalline superconductor 1920 may comprise a so-called superconductor tape, such as REBCO tape. Illustrative dimensions of a tape may include a thickness of between 0.001 mm and 0.1 mm, and a width of between 1 mm and 12 mm. According to some embodiments, polycrystalline superconductor 1920 may exhibit high alignment of grains (may be "grain-aligned"). As used herein, "grain-aligned" polycrystalline superconductors may include, but are not limited to, polycrystalline superconductors that exhibit less than 10% grain boundary misalignment.

As noted above, "REBCO" is an acronym for "rare-earth barium copper oxide." As used herein, in at least some cases "REBCO" may be used to refer more generally to any rare-earth cuprate HTS. As such, unless expressly stated otherwise, barium may be present in REBCO, but is not required to be present.

Polycrystalline superconductor 1920 may comprise only superconductor material. According to an embodiment, polycrystalline superconductor 1920 comprise a coated superconductor material in addition to other materials. For instance, a REBCO tape may be arranged with conductor and buffer layers to produce a coated-conductor tape as shown in the example of FIG. 2, then arranged in system 1900 so that neutrons and optionally ions are incident upon the coated-conductor tape.

According to some embodiments, during operation of system 1900, the portion 1921 of the polycrystalline superconductor may be held at a temperature of greater than or equal to 10K, 20K, 40K, 60K or 70K. According to some embodiments, during operation of system 1900, the portion 1921 of the polycrystalline superconductor may be held at a temperature of less than or equal to 80K, 77K, 70K, 40K or 30K. Any suitable combinations of the above-referenced ranges are also possible (e.g., a temperature between 20K and 70K). The temperature of the portion 1921 of the polycrystalline superconductor may be achieved through any suitable technique or device, including through contact with cryogenic liquids, such as liquid helium or liquid nitrogen.

FIG. 20A is a schematic illustrating a cross-section of a fusion reactor, according to some embodiments. As discussed above, a magnet within a fusion reactor may be formed from polycrystalline superconductor, and may be separated from the reactor core (where a plasma is formed to undergo nuclear fusion) by a neutron shield. FIG. 20A shows a cross-section through a reactor and includes a magnet coil 2011, which is fabricated from, or otherwise includes, a polycrystalline superconductor, a neutron shield 2012, and core region 2013.

According to some embodiments, neutron shield 2012 may comprise one or more materials suitable for moderating high energy neutrons ("fast" neutrons) and/or suitable for absorbing thermal neutrons. For instance, neutron shield 2012 may comprise one or more polymers which comprise a high number of light atoms, such as polyethylene (which may be borated and/or deuterated), and/or titanium hydride ($TiH_2$). In some cases, neutron shield 2012 may comprise a metal such as steel plates (e.g., borated and/or ferritic stainless steel plates). In some embodiments, neutron shield may comprise multiple layers, such as an inner layer to moderate neutrons (e.g., polyethylene) and an outer layer to capture thermal neutrons (e.g., borated steel). According to some embodiments, neutron shield 2012 may comprise boron carbide ($B_4C$).

As discussed above, the inventors have recognized and appreciated that neutrons incident on a polycrystalline superconductor may cause limited degradation of the superconductor, and in some cases may even enhance its electrical characteristics, and that as a result, fusion reactors with less shielding may be fabricated, allowing more compact reactors to be made. A thickness of the neutron shield 2012 may therefore be determined based on an understanding of these effects, and as a function of the power output of the reactor and its lifetime, as follows.

An expected lifetime of a polycrystalline HTS deployed in a fusion reactor may be expressed as follows:

$$L = \frac{\phi}{f_r PC}$$

where L is the expected lifetime, $\phi$ is the critical fluence of neutrons expected to cause degradation of the HTS such that the critical current drops below some nominal value (e.g., the value of the critical current when the HTS is first installed in the reactor), $f_r$ is a neutron attenuation factor and is a function of shield thickness, P is the expected mean power output in megawatts (MW) of the reactor over the lifetime L (referred to henceforth as the "rated power output"), and C is a constant conversion factor for dimensional purposes and includes an expected available/uptime of the reactor over the lifetime *L*. $f_r$ is an exponential function of the thickness of the neutron shield t, and the above can be reexpressed assuming a critical neutron fluence $\phi = 3 \times 10^{19}$ neutrons/cm$^2$ as:

$$t = -6.85\, ln\left(\frac{1.2}{PL}\right)$$

This empirical formula may be employed to determine a suitable thickness (in centimeters) of the neutron shield for a reactor with a given rated power output in MW and over a given lifetime period in years based on the above-described recognition of the inventors. For instance, for a reactor with a 500 MW rated power output and having a lifetime of 15 years, the thickness is approximately 60 cm. This may represent a smaller thickness than may conventionally be understood to be viable in a fusion reactor for a 500 MW reactor with a 15 year lifetime.

The above-equation may be approximated and simplified further to relate the rated power output in MW to a range of thicknesses of the shield in cm, wherein reasonable values of the lifetime are encompassed by the range of values. In particular, the thickness in cm may be written as a function of the power in MW as follows:

$$t = AP^B$$

where A and B are constants.

According to some embodiments, A may have a value greater than or equal to 20, 22, 25, 27, or 30. According to some embodiments, A may have a value less than or equal to 42, 40, 37, 35, 32, or 30. Any suitable combinations of the above-referenced ranges are also possible (e.g., A may be between 25 and 35). According to some embodiments, B may have a value of 0.08, 0.09, 0.10, 0.11, or 0.12. Any suitable combination of the above-referenced ranges for the value of A may be combined with any of these values of B. For instance, in some embodiments t may be between $25 \times P^{0.1}$ and $35 \times P^{0.1}$ (between approximately 47 cm and 65 cm for a reactor rated at 500 MW); in some embodiments, t may be between $22 \times P^{0.11}$ and $32 \times P^{0.11}$ (between approximately 44 cm and 63 cm for a reactor rated at 500 MW).

FIG. 20B is a three-dimensional graphic of a fusion reactor with a cutaway portion illustrating various components of the reactor, according to some embodiments. Illustrative reactor 2000 depicts a magnet coil 2021, which is fabricated from, or otherwise includes, a polycrystalline superconductor, and core region 2023. A neutron shield is not depicted in the example of FIG. 20A but may be arranged between the coil 2021 and the core region 2023 at the located 2021 highlighted with a white ellipse.

According to some embodiments, in operation magnet coil 2011 and/or magnet coil 2021 comprise a polycrystalline HTS and may be held at a temperature that is below the superconducting transition temperature of the HTS. As discussed above, since the negative effects of incident neutrons upon the polycrystalline HTS (degradation of grain boundaries) are mitigated at lower temperatures and the positive effects of incident neutrons upon the polycrystalline HTS (creation and/or enhancement of pinning sites) are increased at lower temperatures, there may be a benefit to operate the polycrystalline HTS at a lower, and in some cases much lower, temperature than is necessary to operate the polycrystalline HTS in a superconducting state. For instance, a polycrystalline HTS with a critical temperature above 50K may be operated at around 20K, or a polycrystalline HTS with a critical temperature above 30K may be operated at around 20K.

Further supporting information relating to the above-described techniques are described below. The below description includes discussion of experiments in addition to background material and should not be viewed as limiting in any way.

*Further Discussion of REBCO Superconductors*

As discussed above, rare-earth barium copper oxide ("REBCO") is a ceramic-based high-temperature superconductor ("HTS"). An illustrative crystal structure for REBCO is shown in FIG. 1. Although ceramic-based HTS was first discovered in 1987, large scale production of REBCO HTS conductors was not possible until recently due to the difficulty in manufacturing long strands of REBCO that still retain high performance. Advances in deposition precursor methods such as rolling-assisted, biaxial-textured substrates ("RABiTS") and ion beam-assisted deposition ("IBAD") have allowed the production of kilometer-length strands of REBCO in the past few years, opening up the possibility of using HTS to wind large bore magnets for use in fusion devices, among other applications.

Previously, the maximum on-coil magnetic field strength in a superconducting tokamak fusion device was limited to approximately 13 Tesla (13 T), constraining the on-axis field strength to about 6 T for a standard aspect ratio. However, the expanded operational space in field, current, and temperature of REBCO removes this constraint. The lack of significant critical current degradation of REBCO at high magnetic fields allows tokamaks to be designed with much higher on-axis fields. Access to higher fields significantly relaxes plasma physics constraints and allows smaller devices at higher fields to access the same performance as larger devices with lower fields.

Superconducting magnets of all types, both low-temperature superconductors ("LTS") and HTS, are sensitive to high-energy neutron radiation. Typically, however, fusion-relevant HTS irradiation studies tend to focus on large (i.e., major radius R > 6 m) reactors which have ample shielding in the radial build. LTS magnets also require a large amount of electrical insulation which is typically more sensitive to radiation than the superconductor itself. As a result, neutron irradiation studies may focus on the effects of radiation damage only up to a certain amount which is "good enough" to qualify coated conductors for use in a large fusion reactor, measured as a fluence of irradiated particles per unit area. For instance, a fluence of approximately $3\times10^{18}$ neutrons/cm$^2$ of "fast" neutrons with energy > 0.1 million electron-volts (0.1 MeV) may be sufficient for a large reactor. In a large fusion reactor, such as the ITER tokamak, lifetime fluence to its coils is expected to be about $2\times10^{18}$ neutrons/cm$^2$.

In compact, high-field reactors utilizing HTS, however, this situation changes significantly. As high-field magnets allow small, high-performance devices to be designed, the thickness of magnet neutron shielding, particularly in the inboard leg, drops along with the size of the device. While neutrons are the primary energy source in deuterium-tritium ("D-T") fusion, their trajectories are unaffected by the higher magnetic field because they carry no charge. As neutron attenuation is an exponential, as opposed to linear effect, linear reductions in shield thickness lead to exponentially higher neutron fluxes reaching the magnet. In addition, the possibility of designing non-insulated HTS fusion magnets makes the primary radiation-limited material in such a magnet be the superconductor, rather than the electrical insulation. Finally, in order to attain the high performance desired for high-field magnets, the HTS in a compact device may be "subcooled" far below its critical temperature, for example to temperatures between 10-20K. These new conditions motivate an expansion of REBCO irradiation research to higher fluences, with measurements performed at the low temperatures and high fields which will be present in a compact, high-field design.

The wide variety of REBCO tape production methods motivates large-scale irradiation studies to compare radiation effects on different tape compositions under compact reactor-relevant operating conditions such as cryogenic irradiation temperature. Although such studies were performed on $Nb_3Sn$, no facilities currently exist that can perform cryogenic neutron irradiations. Before such facilities were phased out in the 1990's, a small number of cryogenic YBCO neutron irradiations were performed. While these studies showed differences between cryogenic and room temperature irradiations, there is no data at the higher fluences and low temperature / high-field conditions relevant to compact HTS fusion reactors. In addition, the irradiated YBCO samples of these studies were either single-crystal or sintered polycrystalline samples from the early days of HTS development, as opposed to the long-length, high quality, grain-aligned, coated-conductor superconductors available today. FIG. 2 shows a cross-section of the layers of an illustrative coated-conductor REBCO tape.

In the context of superconductor performance for fusion magnets, one suitable figure of merit for assessing "damage" or "enhancement" to the superconductor is the critical current *Ic.* Although *Ic* is a directly measurable quantity, the microscopic physics performance parameter is really the critical current density *Jc* through the cross section of the superconductor itself (neglecting the addition of mechanical and stabilizing layers present in commercial tapes). The quantity Jc can be determined by dividing the measured *Ic* by the width of the coated conductor and the thickness of the REBCO layer, for example as determined by tunneling electron microscope ("TEM") measurements, and is referred to as a tape performance metric below.

As REBCO is irradiated, a wide variety of changes may occur within the ordered superconducting crystal lattice, and competing effects on *Jc* may emerge. On one hand, the displacements of atoms and creation of defect clusters has the tendency to lower *Jc* through one or more of: (a) suppression of the superconducting critical temperature *Tc,* (b) lattice amorphization, (c) degradation of intergrain current transfer, and (d) the disordering of intrinsic pinning sites. On the other hand, (e) point defects and defect clusters can act as artificial pinning centers, increasing *Jc* by the creation of beneficial pinning sites. The cumulative effect of these mechanisms can be observed as a net increase or decrease of measured *Jc*. A summary of these mechanisms, some of which were already described above in brief, is presented below.

*(a) Suppression of Critical Temperature*

One mechanism by which *Jc* may be degraded through irradiation of superconductors comes through suppression of the critical temperature *Tc* by means of the accumulation of radiation-induced defects. Near *Tc,* the dependence of *Jc* on temperature can be given by Ginzburg-Landau ("GL") theory as:

$$J_c = J_0\left(1 - \frac{T}{T_c}\right)^{(3/2)} \qquad (1)$$

Thus, a degradation of *Tc* will lead to a reduction of the critical current *Jc.* The chemical reason for *Tc* degradation in YBCO superconductors is understood to be related to the oxygen deficiency $\delta$ of $YB_2Cu_3O_{7-\delta}$, which is a measure of the "doped hole concentration" p, defined as the concentration of holes per Cu atom in the $CuO_2$ planes. *Tc* varies parabolically with hole concentration, with an optimum hole concentration of $p \approx 0.16$ as seen in FIG. 3.

The explanation for the effect of hole concentration on *Tc* has been theorized to be enhanced electron scattering due to the added magnetic and non-magnetic impurities leading to "de-pairing" of the Cooper pairs carrying the supercurrent. This scattering occurs in the superconducting $CuO_2$ planes as more Cu and O vacancies are introduced.

The other microstructural explanation for pair breaking is related to the structure of the cuprate lattice. As mentioned above, the oxygen stoichiometry of cuprate superconductors may have a large influence on the lattice parameters and structure of the superconducting crystal. At a $\delta$ value of approximately 0.6, a phase transition from tetragonal to orthorhombic occurs in the crystal lattice of the cuprate. This observation led to the development of a "charge reservoir/transfer" model where Cu-O chains act as reservoirs for charge at the $CuO_2$ superconducting planes. The disorder of the Cu-O chains affects the number of electron holes (i.e., charge carriers) available to the $CuO_2$ planes. Radiation damage leading to *Tc* degradation differs from full amorphization of the superconducting lattice, as the $CuO_2$ planes damaged as described above can still carry supercurrent. From a microstructural point of view, the type of damage leading to *Tc* degradation is defects or small clusters of point defects.

*(b) Lattice Amorphization*

The second general type of radiation damage that can occur in superconductors is full amorphization of the superconducting lattice, leading to normal (i.e., non-superconducting) regions within the superconductor. The filamentary model of Moeckly et al. describes a high temperature superconductor as "a composite system consisting of a network of superconductive filaments embedded in a non-superconductive matrix", with the size of the filaments being on the order of the superconducting coherence length, $\xi$. As defect clusters and cascades are introduced into the superconducting material, the network of superconducting filaments becomes less and less dense until the superconducting state collapses completely.

Some experiments have observed the formation of an intragranular "cellular" microstructure of superconducting cells with a diameter of about 5-10 nm surrounded by highly amorphous regions in irradiated YBCO crystals. The onset of this microstructure corresponded to a rapid degradation of *Tc* (and thus *Jc)* suggesting the complete blockage of supercurrent by these cellular boundaries. An interesting observation was that the onset of the cellular structure was highly dependent on both the original superconductor quality (defined as the sharpness of transition between superconducting and normal state) and the type of irradiation. Cellular onset was observed at a calculated displacements-per-atom ("DPA") of 0.07 for ion irradiations but only 0.003 for neutron irradiations, suggesting that this structure was only created by the large cascades produced by the high-energy recoils characteristic of neutron irradiation. Other experiments with higher quality YBCO crystals did not observe the onset of cellular microstructure for fluences up to $8\times10^{17}$ n/cm$^2$ and it was hypothesized that it would require fluences on the order of about 5-$10\times10^{18}$ n/cm$^2$ to observe the onset of the cellular microstructure based on high-fluence ion irradiations of the improved YBCO crystals.

*(c) Grain Boundary Disorder*

For coated conductors such as REBCO tape, there is a difference between critical current within grains and between grains. Grain boundary misorientations of even a few degrees lead to bulk degradation of the sample *Jc* of factors of 10 to 50, and the application of magnetic fields only increase this deleterious effect. The microstructural mechanisms between lattice (intragrain) and grain boundary (intergrain) current degradation are similar and related to weak coupling between the superconducting filaments.

Weak coupling arises due to the "Josephson effect", a macroscopic manifestation of the quantum mechanical nature of superconductors. The Josephson effect is the property of supercurrent to flow through a thin (about 1 nm) insulating layer (referred to as a "Josephson junction") due to quantum tunneling. Within the filamentary model of HTS superconductors, filaments can be connected by these weak links, allowing the so-called "glassy" superconducting phase to occur within a single grain. Early experiments showed evidence for two distinct contributions to critical current density, a "weak link coupling"-dominated contribution and a pinning contribution, the former contribution being dominant at low fields and the latter contribution being dominant at high fields. While intragrain weak coupling was shown to exist at extremely low fields, the more relevant weak coupling regime for fusion applications exists for intergrain (grain boundary) coupling, which can exist up to fields of several Tesla in unirradiated superconductors.

Typical grain boundaries in coated conductors are on the order of a nanometer. For example, FIG. 4 shows a TEM image of an illustrative YBCO superconductor having a 30 degree [001] tilt grain boundary whose structural units have been highlighted to show the approximate width (about 1 nm) of the grain boundary. As a bulk HTS coated conductor is irradiated, its grain boundaries will act as sinks to defects and widen, becoming progressively stronger barriers to transport current as the grain exceeds the coherence length. Current transport through a grain boundary can be calculated as $Jc = J_0 \exp(-2\kappa\Delta)$, where *Jc* is the tunneling current density through the boundary, $J_0$ is the current density at the boundary, $\kappa$ is the decay constant, for example 7.7 nm$^{-1}$, and $\Delta$ is the width of the boundary interface. Thus, as the HTS is irradiated, weak link coupling due to grain boundary widening will become the dominant effect limiting critical current density at higher and higher fields as *Jc* drops below the pinning-limited *Jc.* An observed crossover in transport *Jc* vs. *B* curves for irradiated and unirradiated coated conductors can be used to approximately determine the field at which critical current changes from a grain-boundary-limited regime to a flux-pinning-limited regime.

*(d) (e) Flux Pinning*

The final way that irradiation can influence superconductor properties is through flux pinning effects. In particular, the property of Type II superconductors allowing lines of magnetic flux to penetrate the superconductor can affect the critical current. As current is passed through the superconductor, the flux lines in the normal cores will experience a Lorentz force:

$$\vec{F_L} = q\vec{v} \times \vec{B} \qquad (2)$$

This force will cause the flux lines to move and will only be counteracted by a "pinning" force exerted by defects in the superconducting material which hold the flux lines in place, as shown in FIG. 5 for different types of defect configurations described below.

The mechanism responsible for the pinning force is the same thermodynamic mechanism responsible for flux inclusion of Type II superconductors described above, for which free energy density plots are shown in FIG. 5A. In a Type II superconductor, it is energetically favorable for flux lines from an applied magnetic field (above the first critical field) to penetrate some of the superconducting regions, transforming the pure superconductor into a mixed state of superconducting and normal regions. In this way, the system reaches equilibrium when a certain amount of flux has penetrated the superconductor. However, if normal or partially normal regions already exist due to the presence of defects, the free energy density of a flux vortex is reduced when it is at a pinning site, creating a potential well for the flux line.

In general, the existence of more pinning sites increases the total pinning force, and thus the critical current value. Pinning sites can be classified into many different categories, summarized below.

A first pinning classification is simply whether the pinning sites are intrinsic to the ideal superconducting lattice or whether they are extrinsic, or artificially produced. In REBCO, for instance, the large asymmetry between current-carrying capacity depending on field orientation arises from the fact that the Cu-O chain layers act as 2D intrinsic pinning centers to magnetic flux lines parallel to the ab plane of the tape.

A second pinning classification relates to the length over which the pinning force operates. Referring to FIG. 5A, two length scales relating to flux vortices are the penetration depth ($\lambda$) and aforementioned coherence length ($\xi$) where $\lambda$ is the length scale for the screening current vortices and $\xi$ is the length scale for the normal cores. For YBCO, since $\lambda$ is approximately 100 times the value of $\xi$, it may be more effective to introduce pins on the order of $\xi$ (about 1 to 4 nm) to maximize the pinning density, so artificial sites such as BZO nanorods or $RE_2O_3$ precipitates on the order of a few nm may be introduced to increase performance. In the context of radiation damage, many of the observed defect clusters created in REBCO by neutron irradiation are on the order of several nanometers, comparable to $\xi$.

A third classification is the strength of the pins. Strong pinning sites distort the flux line lattice itself and are generally very stable against thermal motion due to the vibration of lattice atoms at high temperatures. Weak pinning sites act collectively, and the shape of the flux line lattice may be preserved. An example of a strong pinning site would be a BZO nanorod or $RE_2O_3$ precipitate. Weak pinning sites are smaller in size, such as point defects or small defect clusters. To illustrate the difference, FIG. 5 shows a superconducting material 10 that includes a strong pinning site 12 that deforms the flux lines of the magnetic field and a weak pinning site 14 that does not.

The volumetric pinning force associated with strong pins can be expressed as:

$$F_{p,s} = n_{a,f} f_{p,l} \qquad (3)$$

where $n_{a,f}$ represents the areal flux vortex density and $f_{p,l}$ is the pinning force per unit length along the pinned flux line. The weak pinning force density can be expressed as:

$$F_{p,w} = \left(\frac{n_{v,w} f_{p,0}^2}{V_c}\right)^{1/2} \qquad (4)$$

where $n_{v,w}$ is the volume density of weak pins, $f_{p,0}$ is the force per weak pin, and $V_c$ is the volume of weak pins acting to pin a single flux line.

The nomenclature "strong" and "weak," as used herein, refers to the strength of the pinning sites relative to the thermal fluctuations in the lattice, not necessarily to their effectiveness at pinning stronger or weaker applied fields. In fact, due to their collective nature, "weak" pinning sites are often dominant at high field conditions because thermal motion may be naturally suppressed at cryogenic temperatures.

A fourth classification is the directionality of the pinning site. Random pinning centers have no particular direction and increase Jc at all applied field angles. However, correlated pinning sites act primarily to pin flux lines in one orientation. For example, BZO nanorods introduced parallel to the c-axis of the superconductor will effectively pin fields applied parallel to the c-axis, but their pinning effectiveness vanishes at other angles. This effect is diminished at lower temperatures and high fields but suggests the desirability of obtaining angularly-resolved *Jc* measurements for the purposes of designing fusion magnets where twisted cable configurations typically used to prevent AC losses and the minimum *Jc* is limiting.

A fifth pin classification is the dimensionality of the pinning site. Point defects are considered 0D pinning sites, and all larger pinning sites can be classified as being 1D, 2D, or 3D. Examples of the larger pinning sites would be BZO columns as 1D defects, Cu-O chain layers as 2D defects, and $RE_2O_3$ precipitates as 3D defects.

*Illustrative Experiment - Overview*

Results for the *Jc* changes of proton-irradiated REBCO tapes at different fluences and irradiation temperatures are presented below. In brief, ion irradiation at cryogenic temperatures was found to substantially reduce the amount of Jc degradation in the REBCO samples irradiated to high fluences, a result with relevance to superconducting REBCO magnets in fusion applications where the radiation will occur at $T \leq 80$ K. An analysis of temperature, field, and angle dependencies of *Jc* suggests that the microstructural mechanism behind the differences of *Jc* with irradiation temperature for a given fluence is two-fold.

The larger effect that degrades *Jc* is that higher-temperature irradiations cause significantly more grain boundary damage, evidenced by the large measured decrease in *Jc* over all fields for the high temperature irradiations. Without wishing to be bound by theory, this effect can be explained by a much larger oxygen diffusion coefficient at high temperatures (modeled through molecular dynamics simulations), leading to the enhanced migration of defects to grain boundary sinks during irradiation. Molecular dynamics simulations suggest that the same mechanism (i.e., enhanced grain boundary disorder) behind the experimentally observed dependence on sample temperature control for ion (e.g., proton) irradiations also applies to neutron irradiations.

The smaller effect is that the creation of effective weak, uncorrelated pinning sites appears to be slightly enhanced at the lower temperature irradiations, opposing *Jc* degradation. This effect is most likely caused by the decreased defect mobility at low irradiation temperatures, leading to the preferential creation of point defects or small defect clusters which act as more effective weak pinning sites. The practical result of this effect is that REBCO performance at high fields is increased, partially canceling out the detrimental effects due to lattice disorder from the irradiation.

Therefore, a first embodiment of these findings is a method comprising irradiating a polycrystalline superconductor with neutrons and optionally protons or larger ions at a cryogenic temperature chosen to effectively eliminate widening, of boundaries of the crystalline grains of the superconductor, caused by diffusion of radiatively displaced atoms. A second, related embodiment is the composition of matter formed by this process.

In some embodiments of either the method or the composition of matter, the superconductor comprises a rare-earth copper oxide superconductor, including but not limited to a REBCO compound. In some embodiments, the cryogenic temperature of the superconductor is at most 80 K, attainable by liquid nitrogen cooling. In some embodiments, irradiating comprises choosing an ion or neutron fluence that maximizes a critical current density in the irradiated superconductor when operating in a condition in which weak magnetic flux pinning dominates strong magnetic flux pinning. In some embodiments, irradiating comprises producing at least 0.003 displacements per atom (DPA). In some embodiments, irradiating forms at least one weak pinning site within the superconductor.

Some application-specific embodiments include providing the irradiated superconductor as a tape. The tape may be coated with at least one electrical conductor. This coated-conductor tape may be used, for example, in an affordable, robust, and compact (ARC) nuclear fusion reactor, and in particular may be wound around a chamber for fusing nuclei of a plasma. Operation of the reactor may include cryogenically cooling the tape and passing an electrical current through it, thereby generating a magnetic field suitable for confining the plasma in the chamber. In some embodiments, cryogenically cooling the wound tape includes "sub-cooling" the tape to a temperature of approximately 20 K-well below the irradiation temperature and the superconducting critical temperature.

In this connection, a third embodiment is a nuclear fusion reactor having at least one toroidal field coil that comprises a polycrystalline superconductor that was irradiated with neutrons and optionally ions at a cryogenic temperature chosen to effectively eliminate widening, of boundaries of the crystalline grains of the superconductor, caused by diffusion of radiatively displaced atoms.

Persons having ordinary skill in the art may appreciate other embodiments of the concepts, results, and techniques disclosed herein. It is appreciated that superconductors irradiated according to the concepts and techniques described herein may be useful for a wide variety of applications. One such application is conducting nuclear magnetic resonance (NMR) research into, for example, solid state physics, physiology, or proteins, for which such superconductors may provide a higher magnetic field (10 T to 25 T) and simpler design than existing systems. Another application is performing clinical magnetic resonance imaging (MRI) for medical scanning of an organism or a portion thereof, for which compact, high-field superconductors are needed without expensive cryogens (such as liquid helium) or extensive maintenance. Yet another application is high-field MRI, for which large bore solenoids are required. Still another application is for performing magnetic research in physics, chemistry, and materials science. A further application is in compact particle accelerators for materials processing or interrogation, where such superconductors as small dipole magnets provide compactness, a high field, stability, and transportability. Another application is in electrical power generators, including wind turbines, as disclosed embodiments are compact, lightweight, and withstand higher temperatures and high magnetic fields. Another application is medical accelerators for, among other things, proton therapy, radiation therapy, and radiation generation generally. Yet another application is in superconducting energy storage, for which disclosed embodiments provide higher temperatures, higher fields, greater stability, and simpler storage device designs. Another application is in magnetohydrodynamic (MHD) electrical generators, in which the higher magnetic field translates to a higher power production efficiency. Another application is in material separation, such as mining, semiconductor fabrication, and recycling, as disclosed small-bore dipole embodiments are robust and tolerate a higher current density and temperature than existing systems. It is appreciated that the above list of applications is not exhaustive, and there are further applications to which the concepts, processes, and techniques disclosed herein may be put without deviating from their scope.

*Illustrative Experiment - Procedure*

Using 1.2 MeV protons provided by the DANTE accelerator at the Massachusetts Institute of Technology ("MIT"), REBCO samples were irradiated to four different fluences ($1\times10^{15}$ p/cm$^2$, $5\times10^{15}$ p/cm$^2$, $1\times10^{16}$ p/cm$^2$, and $5\times10^{16}$ p/cm$^2$) at three different irradiation temperatures (80 K, 323 K, and 423 K). The highest fluence value was chosen to approximately match the displacements-per-atom ("DPA") of 0.003 at which previous studies observed *Jc* degradation due to neutron irradiation. The Robinson Research Institute ("RRI") SuperCurrent system was subsequently used to analyze critical current *Ic* in the irradiated samples, from which *Jc* was calculated.

As discussed above, the irradiation temperature plays a role in the *Jc* degradation induced during irradiation, and in the subsequent impact on *Jc*. This effect can be seen in FIG. 6, displaying the critical current density of samples irradiated at different temperatures to fluences of $1\times10^{16}$ p/cm$^2$ and $5\times10^{16}$ p/cm$^2$. At measurement conditions relevant to a compact, high-field fusion reactor (for example, magnetic field strength 5 T and temperature 30 K), the irradiation temperature is shown to degrade the minimum *Jc* by approximately a factor of 2 between the 80 K and 423 K irradiation at the higher fluence. This result has significant implications for fusion magnets, as all previous REBCO irradiations to determine the lifetime of the superconductor in a fusion environment have been performed at temperatures between 323 K and 383 K.

In at least some cases, the dominant mechanism by which Jc is degraded may be REBCO grain boundary degradation caused by radiation-enhanced diffusion. Since diffusion speed decreases exponentially with temperature reduction, this finding motivates "sub-cooling" of REBCO in fusion magnets far below the critical temperature to promote radiation resistant operation.

FIG. 7 displays the minimum *Jc* vs irradiation temperature for a wide variety of operating conditions and fluences. The plots are arranged so that each column is a different magnetic field strength (increasing from left to right) and each row is a different temperature (increasing from top to bottom). Over all of the conditions shown, FIG. 7 indicates that irradiation temperature has a large effect, where the universal trend to *Jc* degradation is much weaker after cryogenic temperature. This result is therefore relevant to superconducting REBCO magnets in fusion applications where the radiation during operating conditions will occur at T < 80 K.

*Illustrative Experimental Results - Critical Temperature Modifications*

In order to determine the critical temperature, scans of *Jc* vs. *T* were obtained and fit using the GL theoretical dependence described in Eqn. (1) above. Critical temperatures were calculated for all irradiated samples and are shown in FIG. 8. The first noticeable trend is that the critical temperature *Tc* decreases as the irradiation fluence increases. Unexpectedly, for all three fluences the critical temperature are observed to have a weak to nonexistent dependence on irradiation temperature. There is a clear drop in *Tc* between $1\times10^{16}$ p/cm$^2$ and $5\times10^{16}$ p/cm$^2$ fluences. This drop is consistent with the clear break in Jc degradation versus irradiation temperature shown in FIG. 7, and thus suggests the *Tc* effect is at least correlated to the *Jc* degradation. The results in FIG. 8 indicate that while *Tc* does not vary strongly with $T_{irrad}$, there is a measurable difference between *Tc* values for different irradiation temperatures at lower fluences.

*Illustrative Experimental Results - Differentiating Strong and Weak Pinning Regions*

For the purposes of the analysis in the following, it is useful to break the *Jc* measurement parameter space into two broad regimes: strong pinning and weak pinning. As described above in connection with FIG. 5, strong pinning sites distort the flux line lattice itself and are generally very stable against thermal lattice vibrations, while weak pinning sites act collectively to preserve the shape of the flux lattice and are more prone to being unstable to thermal vibrations. Thus, strong pins are more effective in conditions of high temperature and low field, whereas weak pinning sites are more effective at the low temperature and high fields that may be found in a compact fusion reactor.

One way to characterize these regions is by analyzing the variation of log(Jc) with T. The critical current density dependence on weak pinning follows the relationship:

$$J_{c,w} \approx J_{0,w} \times \exp\left[-\left(\frac{T}{T_{0,w}}\right)\right] \qquad (5)$$

where $J_{0,w}$ and $T_{0,w}$ are fit parameters proportional to the critical current density and pinning barrier energy at zero temperature (e.g., without thermal fluctuations leading to flux creep and thermally activated depinning). Equation 5 can be used to roughly approximate regions of the data. If the *Jc* vs *T* trend fits well to Equation 5 it may be deduced that the data relates to the weak pinning regime, and where the data trend deviates from Equation 5, as *T* increases, then this is identified as the transition temperature into the strong pinning regime.

FIG. 9 compares the *Jc* dependences with temperature for several fields (field oriented perpendicular to the tape) in an unirradiated control sample as well as the sample irradiated to $5\times10^{16}$ p/cm$^2$ at 423 K. Dashed vertical lines were plotted to guide the eye to the point where the data deviates from the fit to Eqn. 5 by more than 5%. At zero field, the transition temperature between strong and weak pinning occurs at approximately 64 K and steadily decreases as the applied field increases, ending up at about 52 K for B = 7 T. While the poor resolution of temperature points in the higher field data means that the true transition temperature could be higher than indicated, the plotted result can be used as an approximate transition temperature.

For the range of measurement fields disclosed herein, then, there is a region of operating temperatures below about 40 K that is generally dominated by weak pinning and a region above about 65 K that is generally dominated by strong pinning. This determination may be used to distinguish behavior in one of the two regimes. The range in between these two temperatures is more complicated and appears to depend on the level of irradiation fluence and applied field. Higher fluence and higher applied fields both have the effect of pushing the crossover temperature to lower values. Due to the low resolution of the data, it is difficult to draw strong conclusions about the effect of irradiation temperature on the pinning regimes, although it appears that the transition temperature shifts more strongly as a function of fluence than irradiation temperature.

*Illustrative Experimental Results - Jc vs. $\theta$ Comparisons*

The main group of high-resolution measurements performed at RRI were high-fidelity angularly-resolved Jc measurements performed at several different temperature and field combinations. Figures 10A to 10F show the measured effect of radiation fluence and radiation temperature on the angular Jc dependence under different operating regimes. Each sample was compared to the unirradiated control sample to establish the degree of enhancement or degradation in *Jc*.

In order to investigate the angular Jc changes in both the strong and weak pinning regimes, two cases were compared for each sample. Based on the results of the previous section, the strong pinning condition was chosen to be 77 K, 1 T, and the weak pinning region was chosen to be 30 K, 5 T. The same behavior in the weak pinning regime was observed down to temperatures of 15 K (as expected), but due to the high measurement currents involved and limitations of the measurement device it was not possible to obtain 15 K measurements for all irradiated samples so 30 K was used as a baseline of comparison.

In FIG. 10A, the critical current density *Jc* of the sample, following irradiation at 80 K and low fluence ($5\times10^{15}$ p/cm$^2$), increases approximately uniformly over the entire range of angles and in both pinning regimes, suggesting the inclusion of effective pinning sites in both regimes due to the irradiation. As irradiation fluence is increased to the medium ($1\times10^{16}$ p/cm$^2$) fluence of FIG. 10B and the high ($5\times10^{16}$ p/cm$^2$) fluence in FIG. 10C, *Jc* drops across all angles in the strong pinning regime of superconductor operation. The *Jc* behavior in the weak pinning regime is more complex. As fluence is increased, *Jc* at 90 degrees drops. At 0 degrees, however, *Jc* remains virtually unchanged, and the minimum *Jc* in the region between 0 and 90 degrees actually increases with fluence. This strongly suggests the addition of coherent weak pinning centers as the fluence is increased, but the destruction of the strong correlated pinning from the Cu-O chain layers.

While Figures 10A to 10C show results of irradiation at different fluences at 80 K, Figures 10D to 10F show the same range of increasing fluences at the higher irradiation temperature of 423 K. In contrast to the irradiations performed at 80 K, none of the 423 K irradiations produced *Jc* enhancement for the strong or weak pinning regimes. The decreases in *Jc* are consistent across all irradiations for measurements performed in the strong regime, with increasing relative *Jc* degradation at higher fluences. For the first fluence, this degradation is more or less constant in angle, although for the highest irradiation (FIG. 10F) the 90-degree peak appears to almost disappear completely. It should be noted that there were no 77 K measurement data for the strong pinning regime of FIG. 10F because the critical current *Ic* was too small to be measured, so 50 K measurements were used instead. In the weak pinning regime, *Jc* also degrades increasingly with higher fluences, although this effect is much more pronounced for the 90-degree peak area compared to other angles.

A comparison of the *Jc* vs. $\theta$ measurements at the two irradiation temperatures suggests that partial destruction of the $CuO_2$ planes occurs at both irradiation temperatures at the higher fluences, as observed by the decrease in the 90-degree peaks. In addition, the decrease in *Jc* across all angles in the strong pinning region for both irradiation temperatures indicates that large defect cascades are not being produced by the irradiation at either temperature.

*Illustrative Experimental Results - Jc vs. B Comparisons*

A common way to study the effects of pinning (in the weak pinning regime) for fields with an angle of 0 degrees is to fit the dependence of *Jc* to the applied magnetic field *B* with a power law of the form $Jc \propto B^{-\alpha}$ above fields of 3 T. A higher value of $\alpha$ corresponds to a higher sensitivity of *Jc* to the applied magnetic field (i.e., the *Jc* degrades more rapidly with increasing B), implying less efficient flux pinning. FIG. 11A shows the field dependencies of *Jc* for the unirradiated control sample, with $\alpha$ values of approximately 0.65, consistent with previously reported values for unirradiated tape with BZO nanorod dopants.

The first set of *B*-field dependencies in FIG. 11B for an irradiation temperature of 80 K shows the decrease of a with increasing fluence, suggesting further evidence for the creation of effective weak coherent pinning centers being introduced with irradiation at this temperature. The decrease of $\alpha$ at lower operating temperatures suggests small scale-size defects which would be more effective pinning sites as $\xi$ decreases with T. From a practical view, a lower $\alpha$ is highly attractive because it flattens the *Jc* vs. *B* curve and improves tape viability at high absolute magnetic fields that may be present in compact tokamak reactors.

The second set of *B*-field dependencies in FIG. 11C for an irradiation temperature of 423 K also shows the

decrease of $\alpha$ with increasing fluence and decreasing operating temperature, suggesting that small, effective weak pinning sites are also being produced at this irradiation temperature. However, this decrease in $\alpha$ is smaller, and is also accompanied by a decrease in absolute Jc, unlike the irradiations at 80 K.

The combination of these results implies that the higher-temperature irradiations have less of an effect at suppressing the creation of pinning sites than amplifying the amount of damage done to the superconductor by irradiation, although the creation of pinning sites may be slightly more effective at the lower temperature irradiation. Another possibility is that enhanced defect mobility at the higher temperature irradiation means that point defects (i.e., pinning sites) migrate to grain boundaries faster, leaving less effective pinning sites in the superconducting region. Since both high and low irradiation temperatures lead to a decrease in alpha, this apparently eliminates the possibility that the dependence in irradiation temperature is due to a different pinning mechanism, destruction, or creation at the different temperatures. Note this is consistent with the lack of dependence on irradiation temperature of the crossover temperature for the dominant pinning mechanism.

*Illustrative Experimental Results - Grain Boundary vs. Pinning region*

With *Tc* suppression and the creation or destruction of pinning sites are eliminated as possible mechanisms causing the difference in *Jc* between high and low-temperature irradiation, the two remaining possible explanations for the much higher degradation of *Jc* in the 423 K irradiated samples are lattice amorphization and grain-boundary amorphization. Since the highest fluence irradiation performed ($5\times10^{16}$ p/cm$^2$) corresponds to a DPA of about 0.003, the creation of a cellular microstructure due to lattice amorphization within grains is not expected. In order to investigate grain boundary disordering, irradiated and control curves of *Jc* vs. *B* were analyzed to find the crossover region where grain-boundary limited *Jc* transitions to pinning-limited *Jc,* as described above.

Figures 12A to 12D show crossover between grain-boundary limited Jc and pinning limited *Jc* regimes for irradiations at 80 K. At the low fluences below $1\times10^{16}$ p/cm$^2$ of Figures 12A and 12B, there is no crossover. As fluence is increased to $1\times10^{16}$ p/cm$^2$ of FIG. 12C and $5\times10^{16}$ p/cm$^2$ of FIG. 12D, where noticeable changes in *Jc* vs. $\theta$ are found, then the crossover appears and increases from about 4.5 to about 5.5 T between these two fluences. This behavior of increasing crossover field with fluence is consistent with results in the literature and is also observed for the 323 K and 423 K irradiation series disclosed herein.

It should be noted that at the two higher fluences of Figures 12C and 12D, irradiation appears to have two distinct effects on the *Jc* vs. *B* curves which influence the location of the crossover field. The first effect is a gradual "flattening" of the slope of the curve, which was discussed above as being due to the increase of beneficial pinning centers which lower the value of $\alpha$ and lead to less *Jc* degradation at higher fields. The second effect is a reduction in *Jc* over the entire range of applied fields, effectively shifting the irradiated curve downwards. This downward shift represents the effect of grain boundary disorder. As discussed above, as the REBCO sample is irradiated, its grain boundaries act as sinks to defects and become widened, creating progressively stronger barriers to transport current. As the sample's grain boundaries become wider, the *Jc* will decrease at all applied fields.

In FIG. 13, the 80 K and 423 K irradiations at a fluence of $5\times10^{16}$ p/cm$^2$ are compared. At this fluence, the 423 K irradiation curve (on the right) has shifted downwards far enough that the crossover field (if it even exists) was beyond the capability of the available testing magnet. The lack of an observed crossover field suggests that *Jc* over the entire field region is grain boundary transport limited. When compared to the low-temperature irradiation at the same fluence (on the left) with a crossover field of about 5.6 T, this strongly suggests that grain boundary damage occurs at a much faster rate when a sample is irradiated at elevated temperatures. The large differences in crossover field between cryogenic and heated irradiations at the same fluence indicates that grain boundary disordering is likely the most dominant effect behind the globally observed differences in *Jc* for different irradiation temperatures.

*Illustrative Experimental Results - Comparison with Molecular Dynamics Modeling*

To guide and interpret the experimental studies above, a simulation workflow was developed by combining several software components. The first was DART, a binary collision approximation code developed by the French Commissariat à l'Energie Atomique. The second was SRIM, a Monte Carlo simulator for the Stopping and Range of Ions in Matter developed by James Ziegler and Jochen Biersack, used to model proton irradiation. The third was MCNP, a Monte Carlo simulator for N-Particle radiation developed by the Los Alamos National Laboratory, used to model neutron irradiation for comparison. The fourth code was LAMMPS, a Large-scale Atomic / Molecular Massively Parallel Simulator developed by the Sandia National Laboratories.

First, the irradiating particle energies were found. For ion irradiation, the HTS superconducting tape geometry and composition was modeled in SRIM, and simulated particles of desired energy and species were sent into the material to determine particle energy at the superconducting layer. For fusion irradiation conditions, a MCNP model was used to determine the neutron energy spectrum at the inner midplane position of the fusion magnet. The ion energy or neutron energy spectrum was then passed as an input to the DART code, along with the experimentally measured (for ion irradiation) or predicted (for neutron) fluxes as well as the material composition of YBCO as described above. The DART code then output a cumulative distribution function of primary knock-on atom (PKA) energies generated by an incident irradiation particle. Using a representative sample of PKA energies generated by DART, molecular dynamics simulations on a $YBa_2Cu_3O_7$ lattice generated in VESTA (the Visualization for Electronic and Structural Analysis program developed by Koichi Momma at the Japanese National Museum of Nature and Science) were performed using LAMMPS on the Idaho National Laboratory's Falcon supercomputer. The results of the LAMMPS simulations were post-processed and analyzed in the OVITO (Open Visualization Tool) scientific data visualization package developed by Alexander Stukowski. Multiple simulations were performed to compare the results of using different ion energies, incident particle directions, and irradiation temperatures with the ultimate goal of understanding the mechanisms behind the experimental results and applying them to fusion conditions.

In order to provide a large enough volume to allow full displacement cascades to propagate, a YBCO unit cell (see FIG. 1) was constructed using the VESTA visualization software and repeated to create a 40 x 40 x 16 unit cell simulation volume of $YBa_2Cu_3O_7$ with the a, b, and c axes corresponding to the orthogonal [100], [010], and [001] directions. This corresponds to an approximately 15 nm x 15 nm x 19 nm volume of YBCO and was chosen to be large enough to allow cascades up to 10 keV to take place entirely within the volume but small enough to allow for a tractable computation time. Periodic boundary conditions were assigned to the faces of the volume. In order to model the potentials between atoms in the model, the four-part potential of Chaplot was utilized for long-range interactions and the Ziegler-Biersack-Littmark (ZBL) screened potential was used to model short-range (i.e., knock-on) interactions.

*Illustrative Experimental Results - Defect Formation Comparisons*

To evaluate defect formation for various PKA energies, a Wigner-Seitz defect analysis was performed using the OVITO package at t = 30 picoseconds (ps) using the time t = 0 frame as a reference. Cluster analysis was performed using a baseline Frenkel pair ("FP") generation threshold to determine the cutoff radius for selection of the cluster, effectively "filtering out" the FPs produced by thermal motion from the defects. A comparison between the 80 K and 423 K proton irradiation conditions was performed by computing the number of Frenkel pairs generated for a number of different PKA energies. Each energy condition was simulated three times to determine a mean value and standard deviation of FP generation for each energy. FIG. 14 compares the FP generation at the two temperatures and shows that at low energies, approximately equal numbers of Frenkel pairs are produced in a cascade, whereas at energies ≥ 1 keV the curves begin to diverge, and more FPs are generated at the higher irradiation temperature.

With regards to the proton irradiations, the results described above indicate that at higher temperatures, the higher energy (E ≥ 1 keV) PKAs produce successively more damage than the low energy PKAs. However, the PKA energy distribution function shown in FIG. 15 shows that PKA energies above 1 keV (i.e., $10^3$ eV) are very rare and only make up a few percent of all collisions. Even at the very rare PKA energy of 10 keV (i.e., $10^4$ eV) shown in FIG. 14, the ratio between high-temperature and low-temperature FP generation is only about 1.5, a ratio which decreases as the PKA energy is lowered. Thus, the effect of irradiation temperature on cluster formation was not expected to play a large role in the Jc degradation effects observed experimentally for ion irradiations.

*Illustrative Experimental Results - Oxygen Diffusion in YBCO*

Another way in which irradiation could influence the microstructure of YBCO is through radiation-enhanced diffusion of defects to grain boundaries. As a material is irradiated, the simplified radiation-enhanced diffusion coefficient can be given as:

$$D_{rad} = D_v C_v + D_i C_i \quad (6)$$

where Dv and *Di* are the vacancy and interstitial diffusion coefficients and Cv and *Ci* are the vacancy and interstitial concentration fractions, respectively. As *Cv* and *Ci* are increased during irradiation, the diffusion coefficient (at a given temperature) is also increased. The results of the previous section indicate that for ion irradiation, defect size is not substantially affected by irradiation temperature, so increases in *Cv* and *Ci* due to the creation of Frenkel pairs during irradiation would be expected (on short timescales) to be similar for both high and low temperatures. However, the unirradiated diffusion coefficients are highly dependent on irradiation temperature, as will be shown below.

*Illustrative Experimental Results - Mean-Square-Displacement ("MSD") Simulations*

In order to determine the diffusion coefficient when the system is in thermal equilibrium (and is not being irradiated), a mean-square-displacement ("MSD") analysis was performed in LAMMPS. First, the simulation volume was relaxed for 100 ps from an initial configuration where the velocity of each atom is randomly selected from a distribution centered at the target temperature. After the system relaxation, the motion of atoms relative to the reference state was tracked, and the atomic displacement lengths were recorded along each primary direction for each atom and then averaged over all the atoms in the simulation volume to give mean values of displacement in each principle direction (dx, dy, and dz) at each timestep. The total mean-squared displacement (MSD) was determined by adding the squared directional contributions as:

$$\langle r^2(t)\rangle = \langle dx^2(t)\rangle + \langle dy^2(t)\rangle + \langle dt^2(t)\rangle \quad (7)$$

The total MSD was plotted vs. time in order to determine the diffusion coefficient. Once the system has reached equilibrium, the MSD should be linear with time, and the diffusion coefficient can be determined from Einstein's relation:

$$\langle r^2(t)\rangle = B + 6D\Delta t \quad (8)$$

where $B$ is a constant, $D$ is the total self-diffusion coefficient, and $\Delta t$ is the time elapsed. In order to determine statistically significant results, a large (i.e., greater than 1 Angstrom) total MSD may be desirable, which this may require long simulation times even at high temperatures where the Brownian motion due to thermal vibrations is increased. In order to make the simulations computationally tractable, the simulation volume was reduced to a 10 x 10 x 4 cell and simulations were only possible for temperatures of 700 K and above. FIG. 16 displays the results of an 800 K MSD simulation to a time of 2500 ps. The first about 500-1000 ps are not in equilibrium, as can be seen from the non-linear slope of the MSD. Thus, the fit to Equation 8 was not applied until time t > 1000 ps.

*Illustrative Experimental Results - Calculation of Diffusion Coefficients*

Using the method described above, the atomic diffusion coefficients for oxygen (the fastest-diffusing atom in YBCO) were determined for temperatures of 700, 800, 900, and 1000 K. As mentioned above, long computation times made it impossible to directly determine lower temperature diffusion coefficients, but since diffusion coefficients follow an exponential relationship with temperature, the higher-temperature diffusion coefficients can be plotted vs. temperature and fit with a curve used to extrapolate down to the lower temperature diffusion coefficients with acceptable accuracy.

The fit can be used to extrapolate down to temperatures currently inaccessible with molecular dynamics modeling due to the computationally intractable simulation times required. The results of extrapolation down to the irradiation temperatures disclosed herein are presented in the table below and show an enormous (17 order of magnitude) decrease in the diffusion coefficient value between the experimental heated (423 K) and cryogenic (80 K) irradiations. Additionally, an extrapolation down to 20K shows a diffusion coefficient nearly 100 additional orders of magnitude smaller than at 80 K. This finding suggests that "sub-cooling" REBCO magnets may be desirable when operating in a radiation environment to suppress radiation-enhanced diffusion damage to grain boundaries, as discussed above in relation to FIG. 20B.

| Temperature | Diffusion Coefficient |
|---|---|
| 20 K | $5.9 \times 10^{-137}$ cm$^2$/s |
| 80 K | $3.1 \times 10^{-38}$ cm$^2$/s |
| 423 K | $1.6 \times 10^{-11}$ cm$^2$/s |

It is worth re-iterating that the results in this table are extrapolations which are themselves based on simulations of an ideal material with several approximations. Thus, the absolute values presented above may be rough approximations of the true oxygen diffusion coefficient in the REBCO which was irradiated. However, the large relative difference between the cryogenic and heated irradiations points to greatly enhanced radiation-assisted diffusion at the higher temperature, which is consistent with the hypothesis that enhanced grain boundary disordering occurs at higher temperature irradiations due to increased diffusion of defects to the grain boundaries which act as sinks to the defects.

Over a given time $t$, the distance $d$ that a particle will diffuse can be approximately given as:

$$d \approx \sqrt{Dt} \quad (9)$$

The high fluence ($5 \times 10^{16}$ p/cm$^2$) irradiations took approximately 80 minutes (4800 s). Using this time, the approximate average diffusion distances for the 80 K and 423 K irradiations can be calculated. At 423 K, d = 2.8 $\mu$m, which is on the order of the grain size in modern REBCO conductors. However, at 80 K, d = $1.2 \times 10^{-9}$ A, which is much smaller even than the width of an oxygen atom, meaning that widening of the boundaries of the crystalline grains due to diffusion has been effectively eliminated. While these numbers are approximations, they illustrate the extreme differences between diffusion at the two different irradiation temperatures.

It is appreciated that the amount of grain boundary widening is a function of the diffusion coefficient, which is itself a function of the irradiation temperature. Thus, the amount of grain boundary widening may be controlled by choosing the irradiation temperature. Moreover, it is appreciated that effectiveness of elimination of grain boundary widening may be calculated as a ratio between an actual widening distance and a grain size (e.g., as measured by TEM). For purposes of this disclosure, grain boundary widening is "effectively eliminated" when this ratio is below a predetermined design threshold, which may be (for example) 10%, 5%, 1%, 0.1%, or other percentage of grain size. Alternately, grain boundary widening is "effectively eliminated" when the absolute magnitude of the diffusion distance is below a predetermined design threshold, which may be (for example) 1 $\mu$m, 100 nm, 10 nm, 1 nm, 0.1 nm, or other distance.

The results of this section and the previous section analyzing Frenkel pair generation both support the experimental evidence for grain-boundary disorder as the dominant mechanism limiting *Jc* transport for REBCO irradiated at high temperatures.

*Embodiment of Results in $\alpha$ REBCO Tape*

In accordance with the above results, FIG. 17 is a flowchart for an illustrative method 20 according to an embodiment for manufacturing a superconductor having enhanced critical current density in operating conditions of high magnetic fields and high-energy neutron radiation. The method of FIG. 17 may, for instance, represent one possible way to operate the system of FIG. 19 discussed above.

The method 20 begins with a process 22 of obtaining a polycrystalline cuprate superconductor. The choice of superconductor may be application specific; for example, a highly grain-aligned REBCO superconductor (i.e., a rare-earth cuprate or another ceramic superconductor that may or may not include barium) may be used. It is appreciated that, as discussed above, the polycrystalline superconductor should at least include a substantial atomic fraction of oxygen that can be efficiently displaced by irradiation.

In process 24 the method determines a temperature dependence of a diffusion coefficient for oxygen in the superconducting lattice when subjected to irradiation. This determination process 24 may be implemented by consulting existing tables of such diffusion coefficients, by direct (but routine) experimental observations, by molecular dynamics simulations, or by other techniques known in the art. It is appreciated that, given how many orders of magnitude the coefficient changes between room temperature irradiations and cryogenic irradiations, an exact value for the diffusion coefficient need not be determined, but rather an approximate relationship between the coefficient and temperature sufficient to accomplish the next process 26.

In process 26 the method determines, at least in part on the basis of the physical properties of the superconductor, a maximum temperature at which proton irradiation to a given fluence would not effectively widen grain boundaries. That is, given a mean grain boundary diameter of the superconductor and an irradiation time for the given fluence, calculate the maximum tolerable diffusion coefficient using equation (9) or similar means known in the art, then compare this maximum tolerable diffusion coefficient against the relationship determined in process 24 to identify an approximate maximum tolerable irradiation temperature. The given fluence itself may be determined to maximize a critical current density *Jc* in the irradiated superconductor when operating in a condition in which weak magnetic flux pinning dominates strong pinning.

In process 28 the method includes cryogenically cooling the cuprate superconductor to below the maximum tolerable irradiation temperature. For example, in some embodiments the maximum tolerable irradiation temperature is at least 77.36 K (the boiling point of liquid nitrogen), such as 80 K, so in these embodiments process 28 includes cooling using liquid nitrogen. In other embodiments, the maximum tolerable irradiation temperature may be lower than 80 K, so other cryogens such as liquid neon, liquid hydrogen, or supercritical or liquid helium may be used during irradiation. In some cases, cooling below the maximum tolerable irradiation temperature may be achieved without liquid cryogen and instead employing conduction cooling.

In process 30 the method includes cryogenically irradiating the cuprate superconductor to a given fluence. Irradiation may be performed using apparatus and techniques known in the art, for example as described below. In some particularly advantageous embodiments, the irradiating process 30 produces at least 0.003 oxygen displacements per atom (DPA) of the lattice. Irradiation may thereby produce at least one weak pinning site within the superconductor, ideally many such pinning sites, thereby improving its critical current density under operating conditions of high magnetic fields and high-energy neutron irradiation without degrading critical current density via widening of the superconducting grain boundaries.

Some applications require the superconductor to be used in a tape format. Thus, the method 20 may be extended in a process 32 to form the irradiated superconductor into a tape and coat it with at least one electrical conductor to form a structure similar to (or the same as) that of FIG. 2. Alternately, the cuprate superconductor may be obtained in process 22 already in a tape configuration.

One particularly advantageous application of the above-described concepts, techniques, and structures uses such a coated-conductor tape as the toroidal field coils of a compact nuclear fusion reactor. Thus, the tape may be wound around a chamber for fusing nuclei of a heated plasma. The field coils are operated by cryogenically cooling the tape to below a critical temperature for the (previously irradiated) superconductor, then passing an electrical current through the coated-conductor tape, thereby generating a magnetic field suitable for confining the plasma in the chamber.

*Irradiation Apparatus*

In order to investigate the effect of irradiation temperature on REBCO degradation, ion irradiations of 2G REBCO samples from SuperPower were performed at the DANTE linear tandem accelerator facility at MIT using a 1.2 MeV proton beam. While the primary-knock-on (PKA) energy spectrum of protons on YBCO is much lower than that of neutrons in YBCO, protons have a much lower stopping power in YBCO than heavier ions and can be considered approximately mono-energetic in the superconducting layer. Monte Carlo calculations performed with SRIM, described above, show that the beam will slow down 200 keV in the 2 $\mu$m silver cap layer and the average proton energy is approximately constant. This is in contrast to heavier ions which have a strongly increasing energy to recoils deeper into the layer, effectively producing different damage in different depths of the superconductor.

Effort was taken to ensure uniform areal irradiation over the entire sample. Critical current measured using the four-probe transport method is limited by the most damaged region on the tape, so any irradiation "hot spots" caused by uneven beam coverage would have resulted in artificially low critical current measurements. To ensure beam uniformity, the proton beam profile was first determined by performing intensity analysis of a CCD image of the beam on a gold-coated quartz window the same distance in beam drift space as the REBCO target holder in an adjacent beamline. The beam focus was adjusted so that the beam spot size at 75% of peak intensity was large enough to cover the entire HTS target area.

After a satisfactory beam spot was achieved, the beam was steered onto the REBCO sample holder, where it passed through a set of collimators before impinging on the REBCO target (see FIG. 18A). The first collimator was slightly larger than the desired target outline and removed the heat load from the unused portions of the beam. The second collimator, constructed from G-10, outlined the 6x4 mm irradiation area on the REBCO and had four copper pickups at the edge of each side of the opening to measure instantaneous beam current (see FIG. 18B). The beam was centered on target by ensuring that the measured beam currents were the same on opposing sides of the rectangular collimator opening. The typical instantaneous beam current value on the HTS tape was 300 nA. The sample holder was affixed to a conduction-cooled cryogenic stage capable of reaching temperatures as low as 80 K and was instrumented with cartridge heaters allowing the sample to be heated as well. The cartridge heaters were controlled using a digital proportional-integral-derivative (PID) controller using feedback from thermocouples attached to the sample directly next to the irradiated area, allowing sample temperature to be maintained in the range of 80 K to 423 K $\pm$ 3 K when the beam was on target. During all irradiations, vacuum conditions in the chamber were kept between $10^{-7}$ and $10^{-6}$ Torr. A secondary electron suppression electrode biased to -200 V was used to ensure accurate beam current (and thus accurate fluence) measurements.

*Critical Current Analysis with the SuperCurrent Measurement system*

In order to achieve a large scan of high-fidelity measurements, the accelerator-irradiated samples were brought to the Robinson Research Institute (RRI) in New Zealand for analysis with their automated SuperCurrent measurement system. The SuperCurrent can be operated in automatic mode, sweeping through the desired set of fields (from 0-8 T), temperatures (15-90 K), and field angles (0-180 degrees), and obtaining the V-I transport curves at each combination. Operating in this fashion, the RRI SuperCurrent collected approximately 18,000 *Ic* measurements of the irradiated and control samples.

*Repeatability of measurements and error analysis*

In order to reduce sample variability due to manufacturing processes, all samples were taken from a continuous 3-meter length to ensure that the processing conditions were as similar as possible. To remove the effect of remaining variations, a full characterization of the experimental tape spool critical current was obtained. Since magnetic hysteresis *Ic* measurements rely on the interpretation of a theoretical model, they may be unable to give an absolute measurement of *Ic* and instead it is desirable to calibrate against a transport measurement. However, relative *Ic* measurements can be used to normalize the "initial" critical current from the length if the position of each sample from the 3-meter length is known. In order to apply this correction factor, the position of the control sample was chosen to be the "standard" critical current, and all other currents were scaled relative to this value.

Although error bars are generally not reported for critical current measurements, an attempt was made to quantify uncertainty in the measurements. Repeat measurements of the same sample were performed to establish measurement uncertainty of the SuperCurrent device. Although it would be infeasible to take multiple repeat measurements to calculate error bars individually for each Jc measurement, a dedicated scan was performed on one sample multiple times.

The three values of *Jc* for each measurement condition (field, temperature, and field angle) were averaged, and the standard deviation of the group was computed. The calculated standard deviations were relatively consistent across all angles, fields, and temperatures, with the exception of the 7 T, 30 K measurements around 90 degrees. The explanation for this is most likely due to the high Lorentz forces on the sample at the high current and field bending the sample so that it is not flat with the Hall sensor mounted inside the sample rod. Due to the sharp peak in *Ic* around 90 degrees, even a small discrepancy between the measured Hall angle the actual angle of the sample with the field could cause a large discrepancy between two measurements. Unfortunately, it was not feasible to measure sample deflection during a measurement, so the only way to correct for this error is to compare full angular scans between measurements and note when the 90-degree peaks are shifted. In order to establish error bars for the critical current measurements, the standard deviations were averaged to yield global standard deviation of 1.3%, which was applied to the data analysis above.

Having thus described several aspects of at least one embodiment of this invention, it is to be appreciated that various alterations, modifications, and improvements will readily occur to those skilled in the art.

Further, though advantages of the present invention are indicated, it should be appreciated that not every embodiment of the technology described herein will include every described advantage. Some embodiments may not implement any features described as advantageous herein and in some instances one or more of the described features may be implemented to achieve further embodiments. Accordingly, the foregoing description and drawings are by way of example only.

Various aspects of the present invention may be used alone, in combination, or in a variety of arrangements not specifically discussed in the embodiments described in the foregoing and is therefore not limited in its application to the details and arrangement of components set forth in the foregoing description or illustrated in the drawings.

Further, some actions may be described as taken by a "user." It should be appreciated that a "user" need not be a single individual, and that in some embodiments, actions attributable to a "user" may be performed by a team of individuals and/or an individual in combination with computer-assisted tools or other mechanisms.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

The terms "approximately" and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value. The term "substantially equal" may be used to refer to values that are within ±20% of one another in some embodiments, within ±10% of one another in some embodiments, within ±5% of one another in some embodiments, and yet within ±2% of one another in some embodiments.

The term "substantially" may be used to refer to values that are within ±20% of a comparative measure in some embodiments, within ±10% in some embodiments, within ±5% in some embodiments, and yet within ±2% in some embodiments. For example, a first direction that is "substantially" perpendicular to a second direction may refer to a first direction that is within ±20% of making a 90° angle with the second direction in some embodiments, within ±10% of making a 90° angle with the second direction in some embodiments, within ±5% of making a 90° angle with the second direction in some embodiments, and yet within ±2% of making a 90° angle with the second direction in some embodiments.

Also, the phraseology and terminology used herein is for the purpose of description and should not be regarded as limiting. The use of "including," "comprising," or "having," "containing," "involving," and variations thereof herein, is meant to encompass the items listed thereafter as well as additional items

## Claims

**1.** A method comprising:

irradiating a polycrystalline high temperature superconductor, HTS, tape with neutrons while the HTS tape is at a cryogenic temperature, the cryogenic temperature being between 10 K and 80 K,
wherein the HTS tape has a thickness between 0.001 mm and 0.1 mm, a width between 1 mm and 12 mm, and exhibits less than 10% grain boundary misalignment, wherein the HTS tape comprises a layer of HTS and a buffer layer and is coated with at least one electrical conductor; and
wherein the neutrons have a fluence of at least $1 \times 10^{15}$ neutrons per $cm^2$

2. A method according to claim 1, wherein the HTS tape comprises a rare-earth copper oxide superconductor.

3. A method according to claim 1, further comprising winding the coated tape around a chamber for fusing nuclei of a plasma.

4. A method according to claim 3, further comprising cryogenically cooling the wound tape and passing an electrical current through the tape, thereby generating a magnetic field suitable for confining the plasma in the chamber.

5. A method according to claim 4, wherein cryogenically cooling the wound tape includes cooling to a temperature of 20 K.

**Patentansprüche**

1. Ein Verfahren, das Folgendes beinhaltet:

Bestrahlen eines Bandes aus polykristallinem Hochtemperatursupraleiter, HTS-Band, mit Neutronen, während sich das HTS-Band bei einer kryogenen Temperatur befindet, wobei die kryogene Temperatur zwischen 10 K und 80 K liegt,
wobei das HTS-Band eine Dicke zwischen 0,001 mm und 0,1 mm, eine Breite zwischen 1 mm und 12 mm aufweist und eine Fehlausrichtung der Korngrenzen von weniger als 10 % zeigt, wobei das HTS-Band eine Schicht aus HTS und eine Pufferschicht beinhaltet und mit mindestens einem elektrischen Leiter beschichtet ist; und
wobei die Neutronen eine Fluenz von mindestens 1 x $10^{15}$ Neutronen pro $cm^2$ aufweisen.

2. Verfahren gemäß Anspruch 1, wobei das HTS-Band einen Seltenerdkupferoxidsupraleiter beinhaltet.

3. Verfahren gemäß Anspruch 1, das ferner das Wickeln des beschichteten Bandes um eine Kammer zur Fusion von Kernen eines Plasmas beinhaltet.

4. Verfahren gemäß Anspruch 3, das ferner das kryogene Kühlen des gewickelten Bandes und das Leiten eines elektrischen Stroms durch das Band beinhaltet, wodurch ein Magnetfeld erzeugt wird, das zum Einschluss des Plasmas in der Kammer geeignet ist.

5. Verfahren gemäß Anspruch 4, wobei das kryogene Kühlen des gewickelten Bandes das Kühlen auf eine Temperatur von 20 K umfasst.

**Revendications**

1. Un procédé comprenant :

irradier un ruban de supraconducteur à haute température, HTS, polycristallin avec des neutrons tandis que le ruban HTS est à une température cryogénique, la température cryogénique étant comprise entre 10 K et 80 K, dans lequel le ruban HTS a une épaisseur comprise entre 0,001 mm et 0,1 mm, une largeur comprise entre 1 mm et 12 mm, et présente moins de 10 % de défaut d'alignement de joints de grains, dans lequel le ruban HTS comprend une couche de HTS et une couche tampon et est revêtu d'au moins un conducteur électrique ; et dans lequel les neutrons ont une fluence d'au moins 1 x $10^{15}$ neutrons par $cm^2$.

2. Un procédé selon la revendication 1, dans lequel le ruban HTS comprend un supraconducteur à oxydes de cuivre et de terres rares.

3. Un procédé selon la revendication 1, comprenant en outre le fait d'enrouler le ruban revêtu autour d'une chambre de fusion de noyaux d'un plasma.

4. Un procédé selon la revendication 3, comprenant en outre le fait de refroidir par cryogénie le ruban enroulé et le fait de faire passer un courant électrique à travers le ruban, générant ainsi un champ magnétique approprié pour confiner le plasma dans la chambre.

5. Un procédé selon la revendication 4, dans lequel le fait de refroidir par cryogénie le ruban enroulé inclut refroidir jusqu'à une température de 20 K.

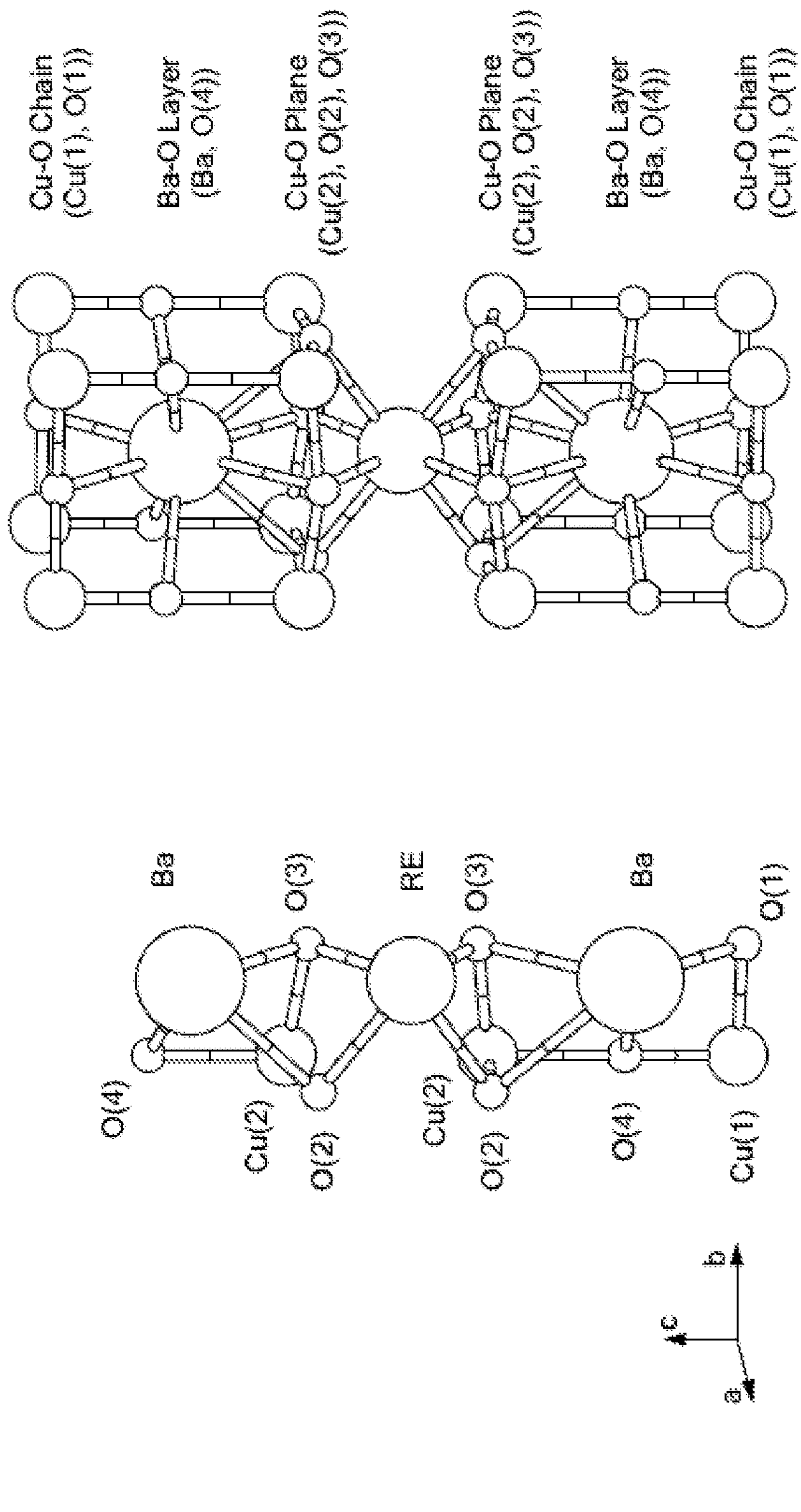
Cu-O Chain
(Cu(1), O(1))
Ba-O Layer
(Ba, O(4))
Cu-O Plane
(Cu(2), O(2), O(3))
Cu-O Plane
(Cu(2), O(2), O(3))
Ba-O Layer
(Ba, O(4))
Cu-O Chain
(Cu(1), O(1))
Ba
O(3)
RE
O(3)
Ba
O(1)
O(4)
Cu(2)
O(2)
Cu(2)
O(2)
O(4)
Cu(1)
c
b
a

*FIG. 1*

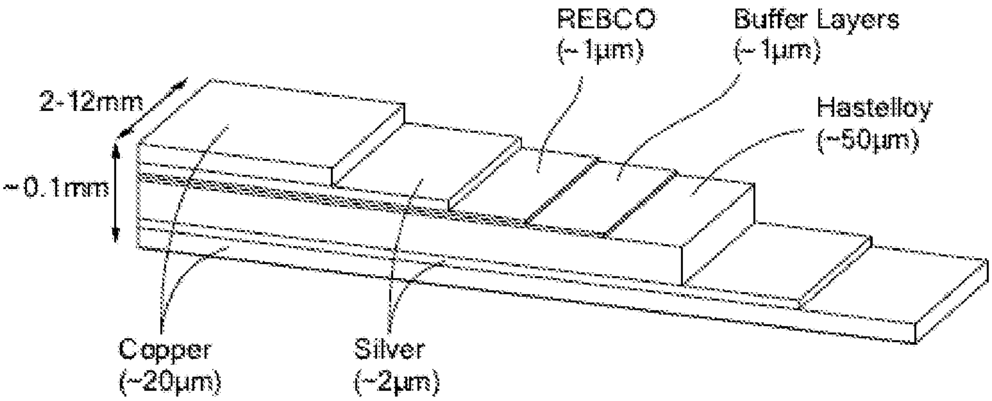
REBCO
(~1μm)
Buffer Layers
(~1μm)
2-12mm
Hastelloy
(~50μm)
~0.1mm
Copper
(~20μm)
Silver
(~2μm)

*FIG. 2*

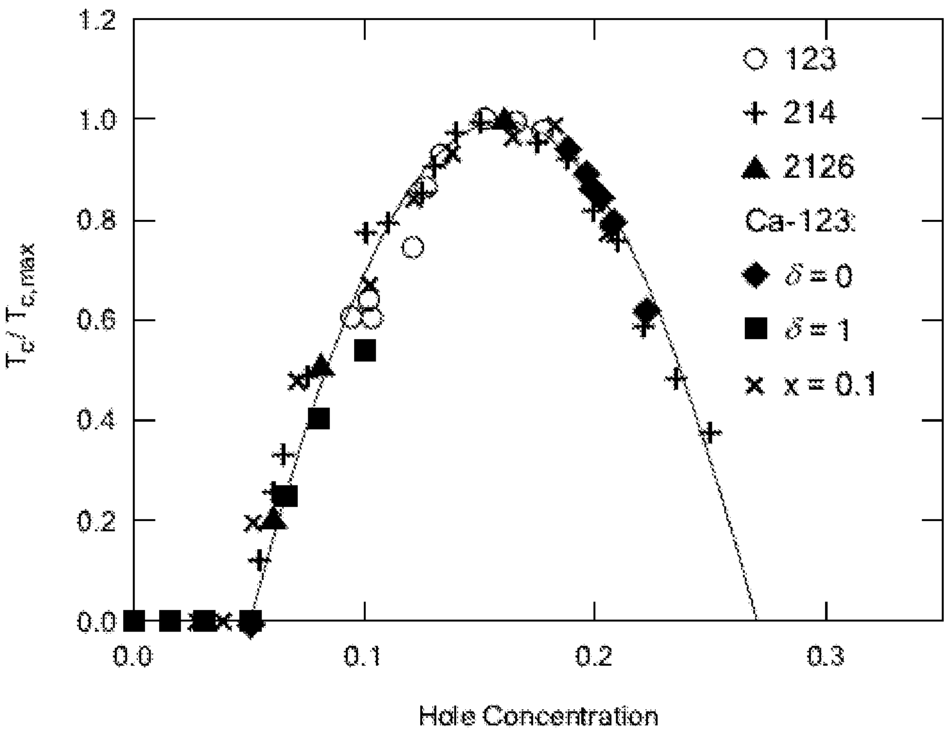
1.2
1.0
0.8
0.6
0.4
0.2
0.0
T_c / T_c,max
0.0
0.1
0.2
0.3
Hole Concentration
123
214
2126
Ca-123:
δ = 0
δ = 1
x = 0.1

*FIG. 3*

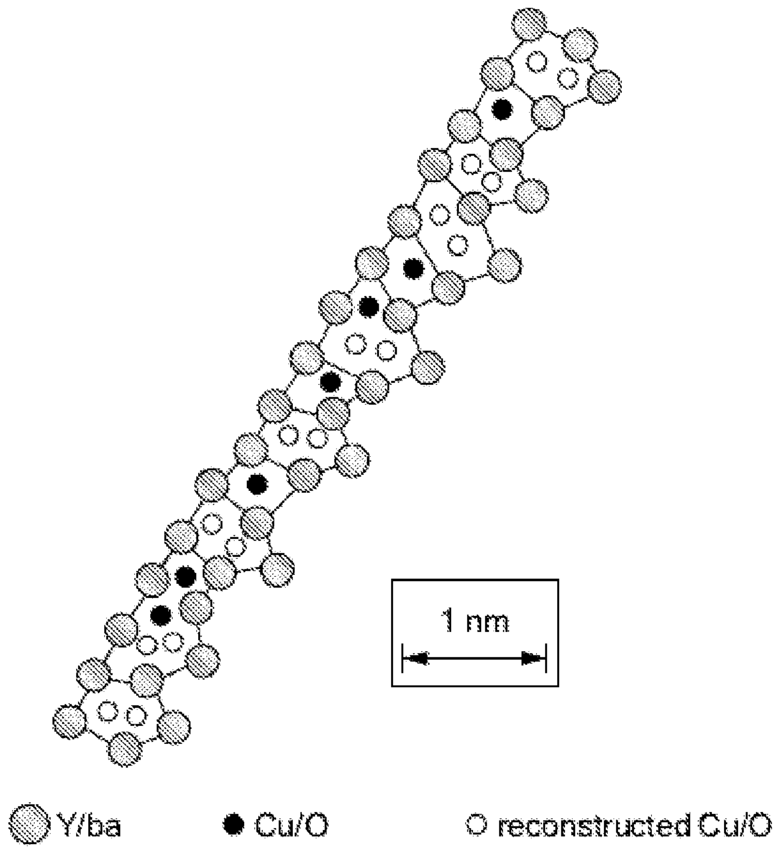
1 nm
Y/ba
Cu/O
reconstructed Cu/O

FIG. 4

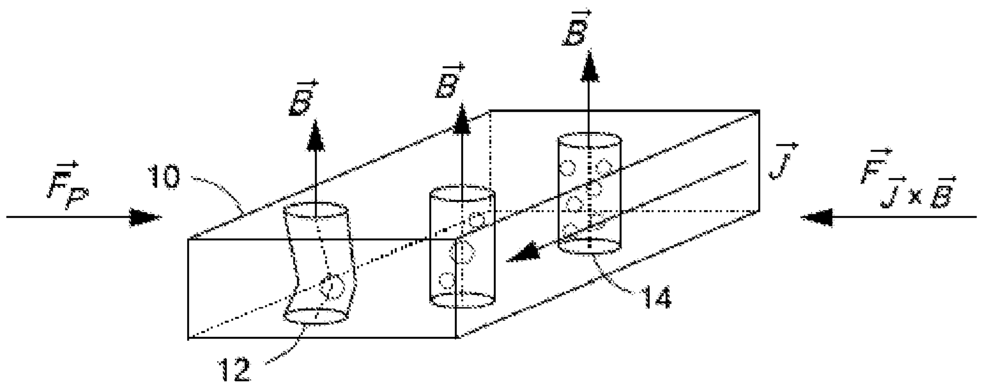
$\vec{B}$
$\vec{B}$
$\vec{B}$
$\vec{F_P}$
10
$\vec{J}$
$\vec{F}_{\vec{J} \times \vec{B}}$
14
12

FIG. 5

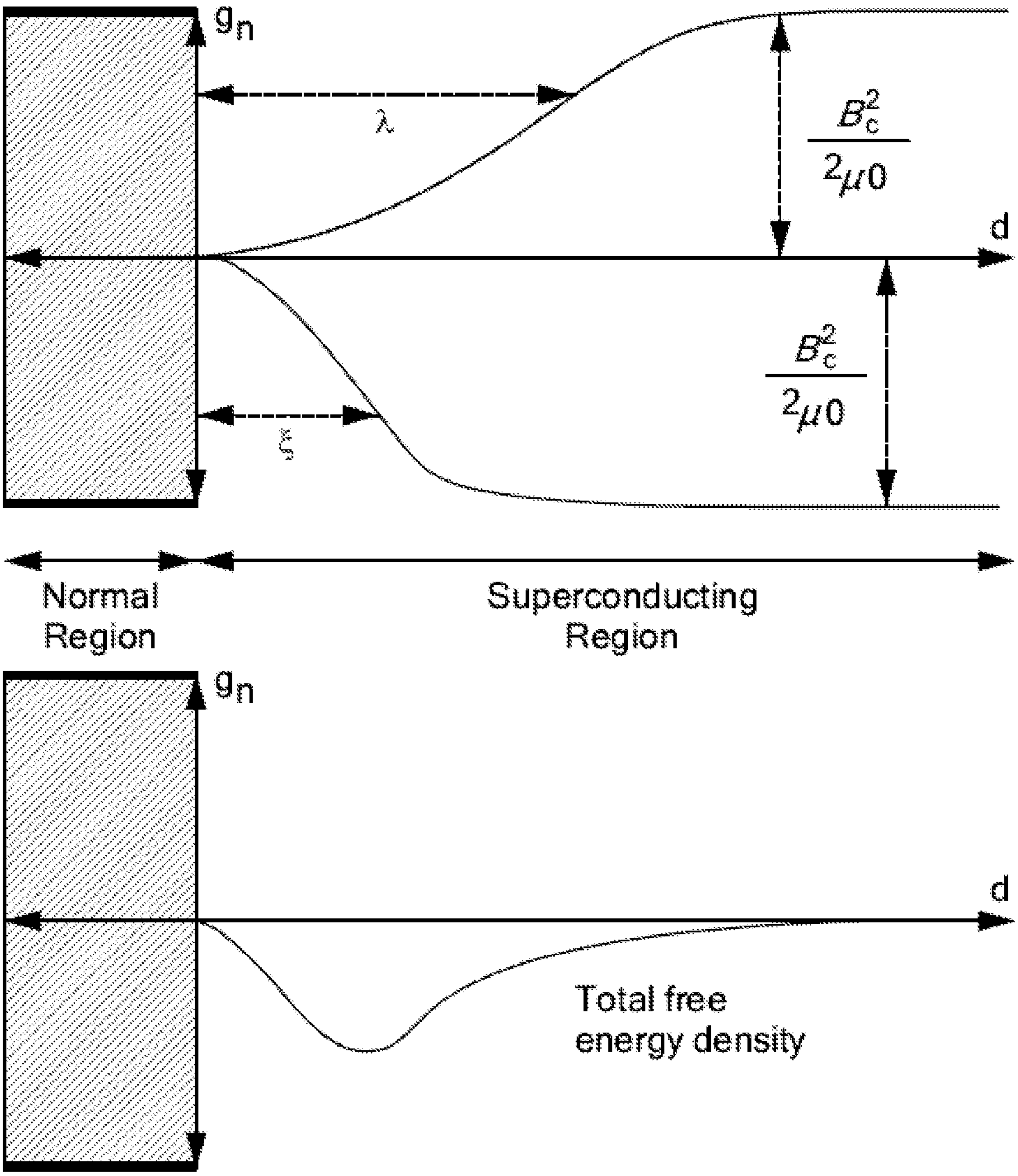

$g_n$
λ
$\frac{B_c^2}{2\mu 0}$
d
ξ
$\frac{B_c^2}{2\mu 0}$
Normal Region
Superconducting Region
$g_n$
d
Total free energy density


*FIG. 5A*

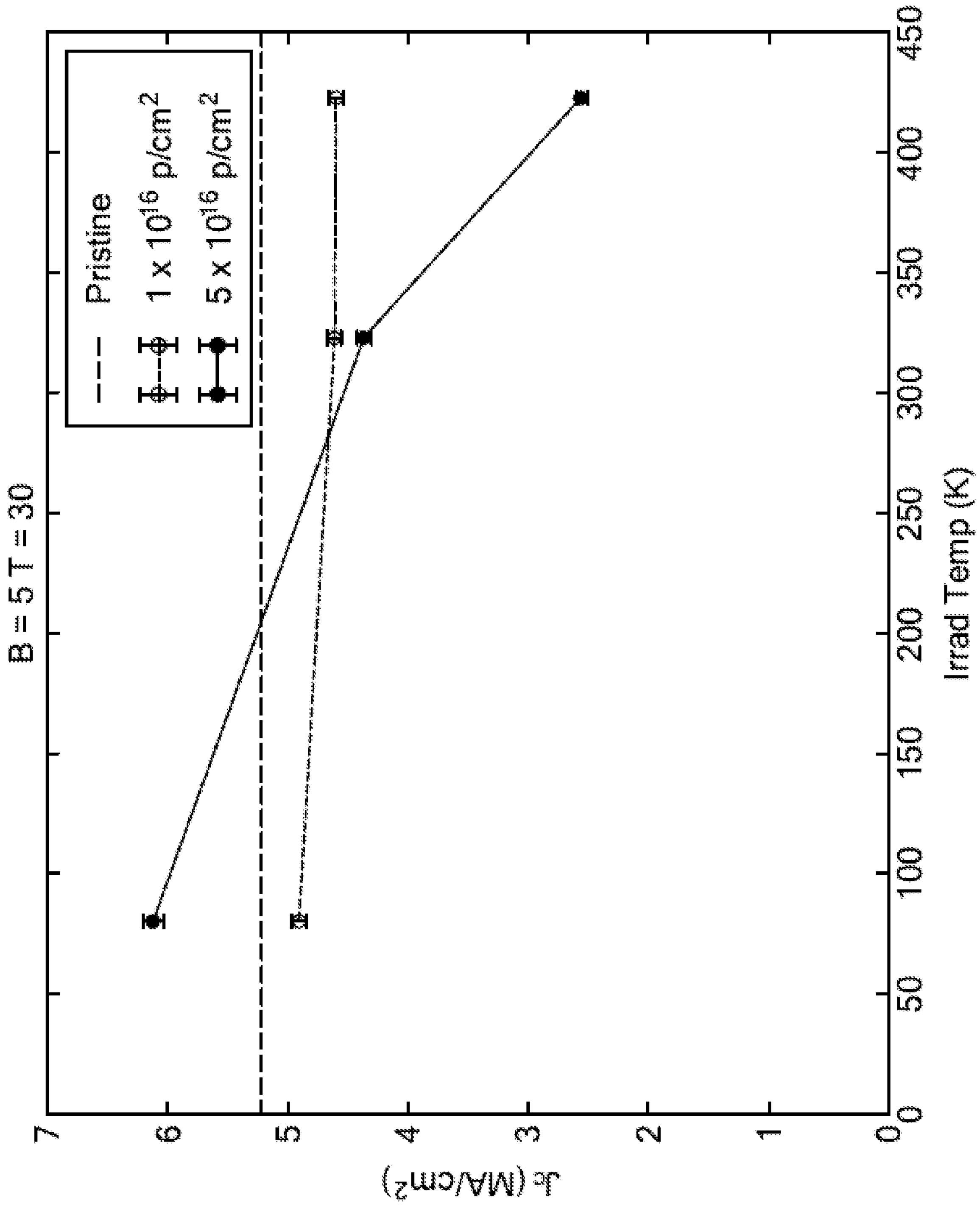
B = 5 T = 30
Pristine
1 x 10^16 p/cm^2
5 x 10^16 p/cm^2
Jc (MA/cm^2)
Irrad Temp (K)
0
1
2
3
4
5
6
7
0
50
100
150
200
250
300
350
400
450

*FIG. 6*

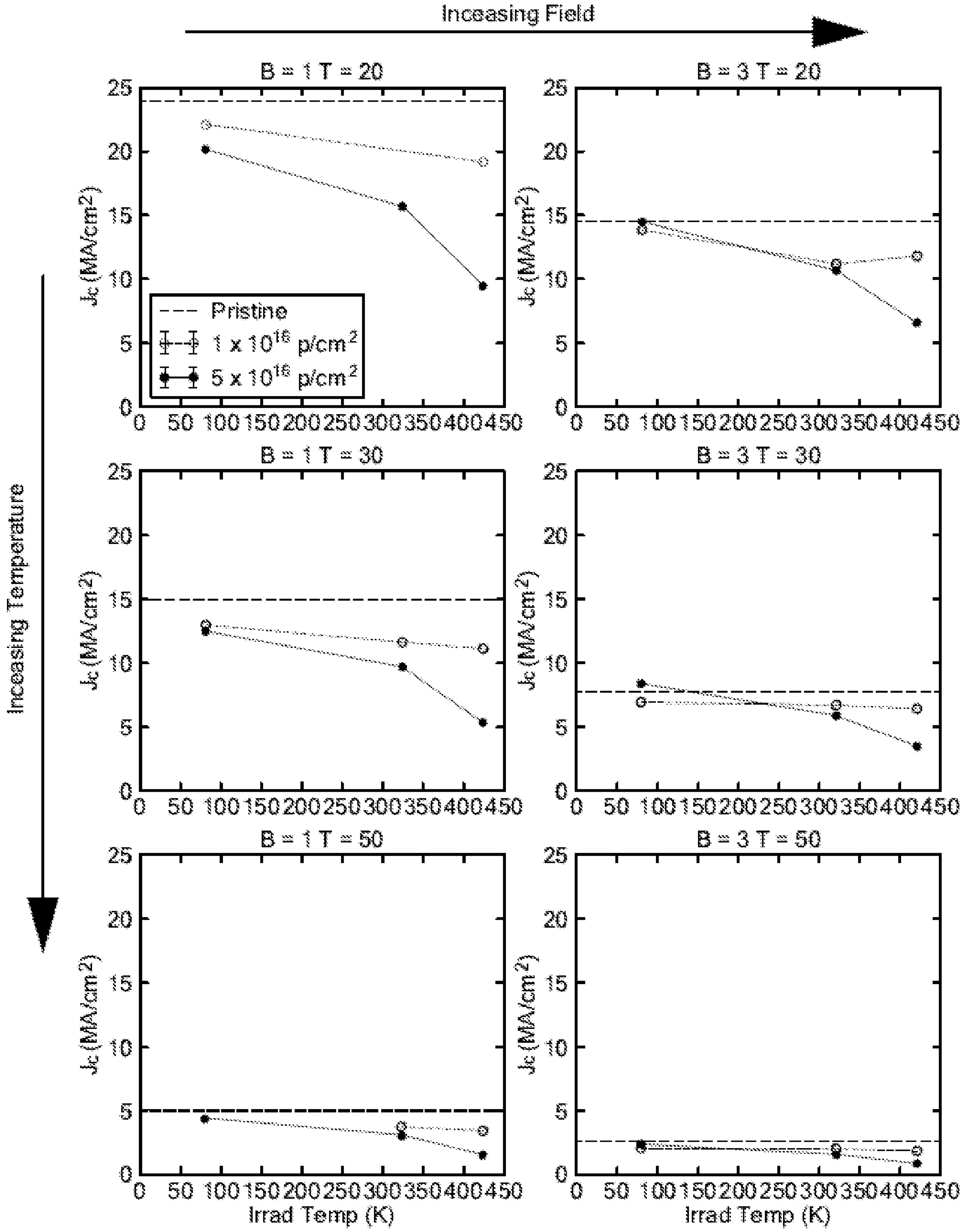

Inceasing Field
Inceasing Temperature
B = 1 T = 20
B = 3 T = 20
B = 1 T = 30
B = 3 T = 30
B = 1 T = 50
B = 3 T = 50
Jc (MA/cm2)
Irrad Temp (K)
Pristine
1 x 10^16 p/cm2
5 x 10^16 p/cm2
0
5
10
15
20
25
0 50 100 150 200 250 300 350 400 450


*FIG. 7*

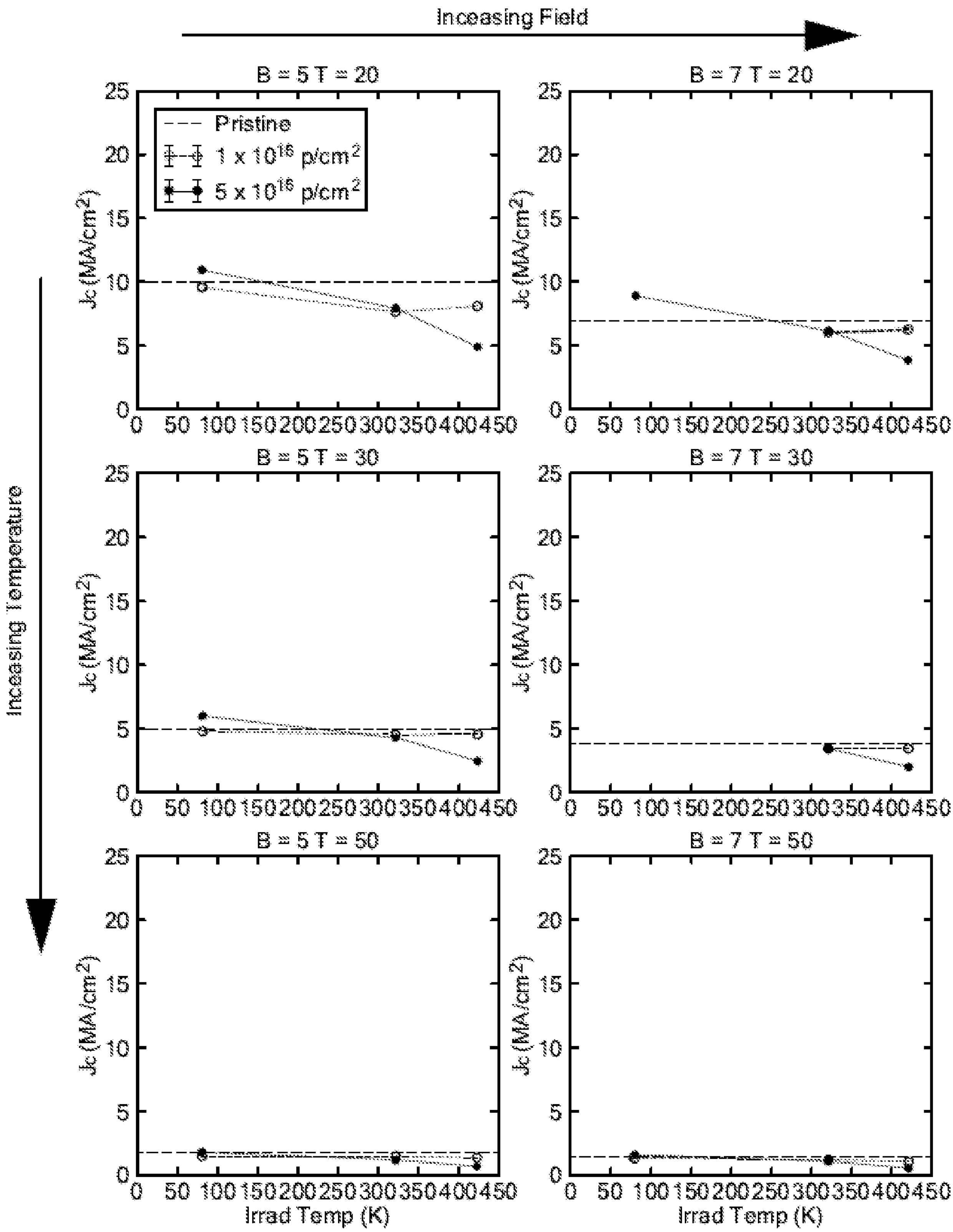
Inceasing Field
Inceasing Temperature
B = 5 T = 20
B = 7 T = 20
B = 5 T = 30
B = 7 T = 30
B = 5 T = 50
B = 7 T = 50
Pristine
1 x 10^16 p/cm^2
5 x 10^16 p/cm^2
Jc (MA/cm^2)
Irrad Temp (K)
0
5
10
15
20
25
0 50 100 150 200 250 300 350 400 450

*FIG. 7*
(cont.)

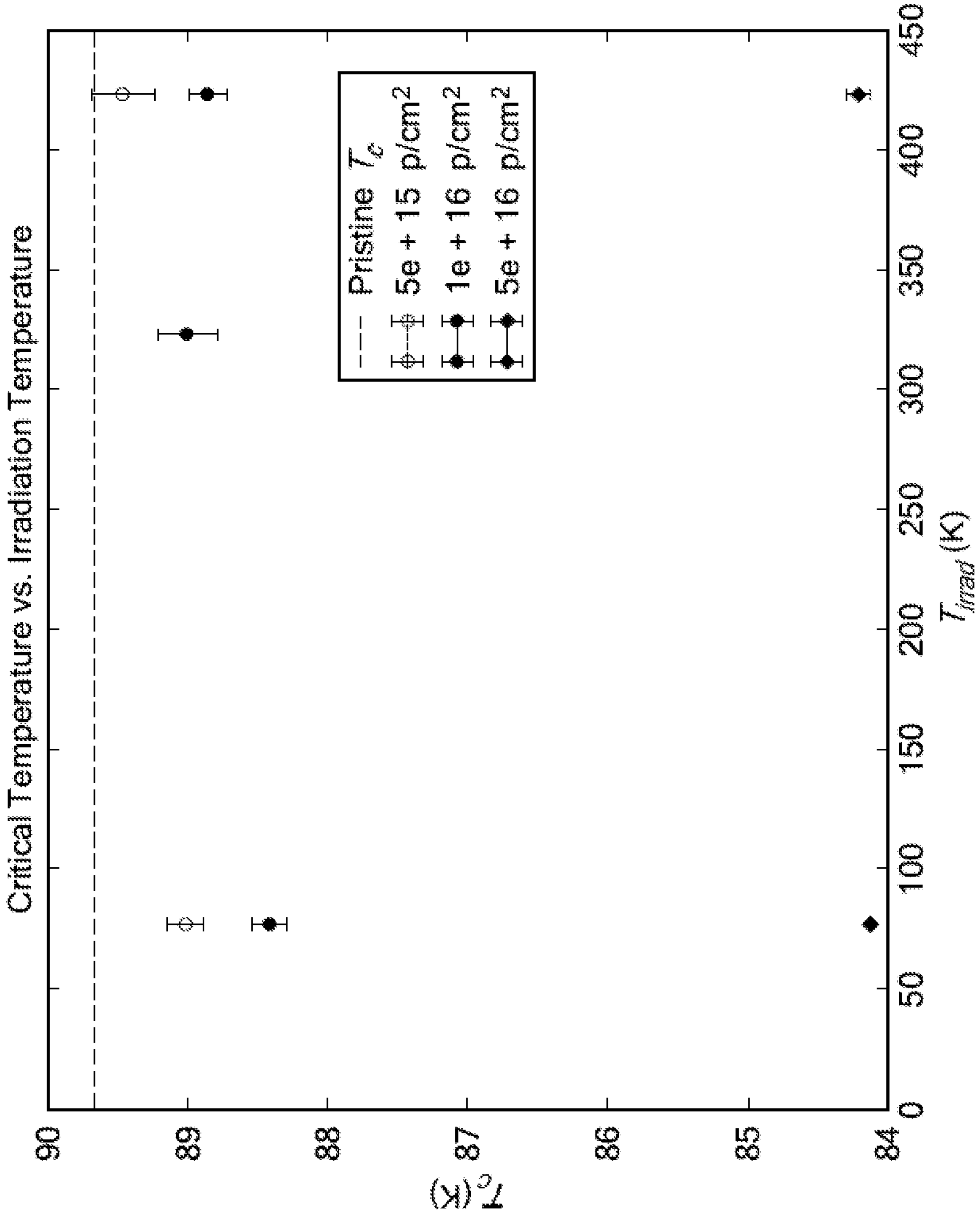
Critical Temperature vs. Irradiation Temperature
$T_c$ (K)
90
89
88
87
86
85
84
$T_{irrad}$ (K)
0
50
100
150
200
250
300
350
400
450
Pristine $T_c$
5e + 15 p/cm$^2$
1e + 16 p/cm$^2$
5e + 16 p/cm$^2$

*FIG. 8*

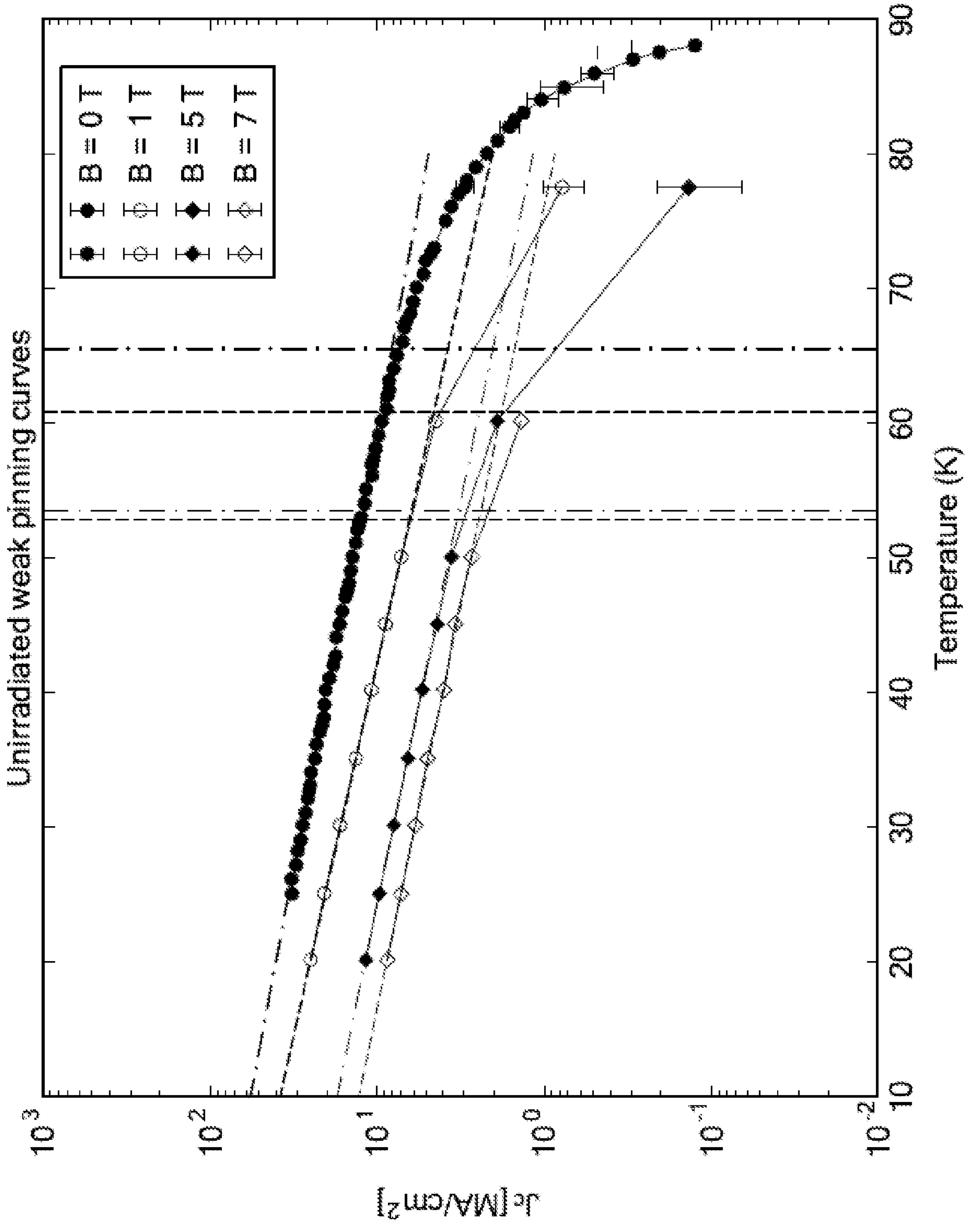
Unirradiated weak pinning curves
B = 0 T
B = 1 T
B = 5 T
B = 7 T
Jc [MA/cm2]
Temperature (K)
10
20
30
40
50
60
70
80
90
10^3
10^2
10^1
10^0
10^-1
10^-2

FIG. 9

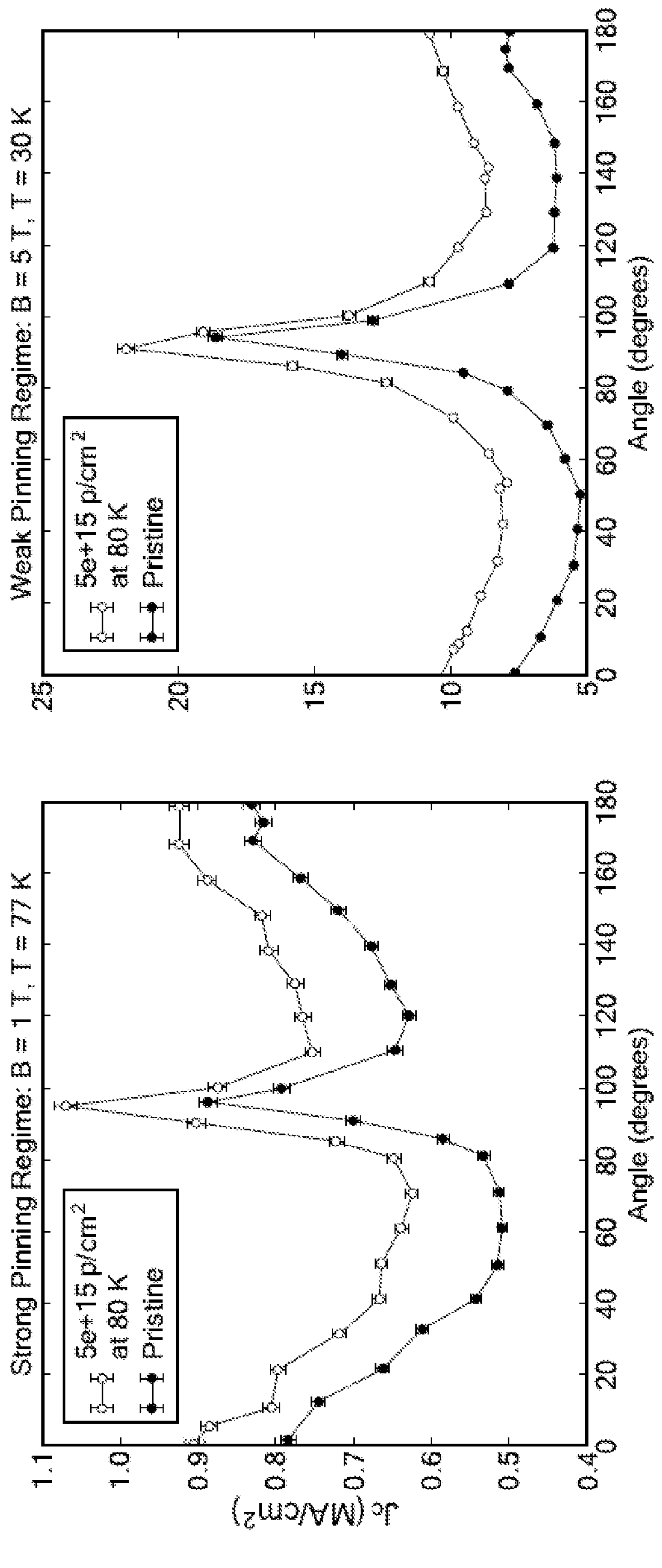

Weak Pinning Regime: B = 5 T, T = 30 K
5e+15 p/cm$^2$
at 80 K
Pristine
Angle (degrees)
Strong Pinning Regime: B = 1 T, T = 77 K
5e+15 p/cm$^2$
at 80 K
Pristine
Angle (degrees)
Jc (MA/cm$^2$)


*FIG. 10A*

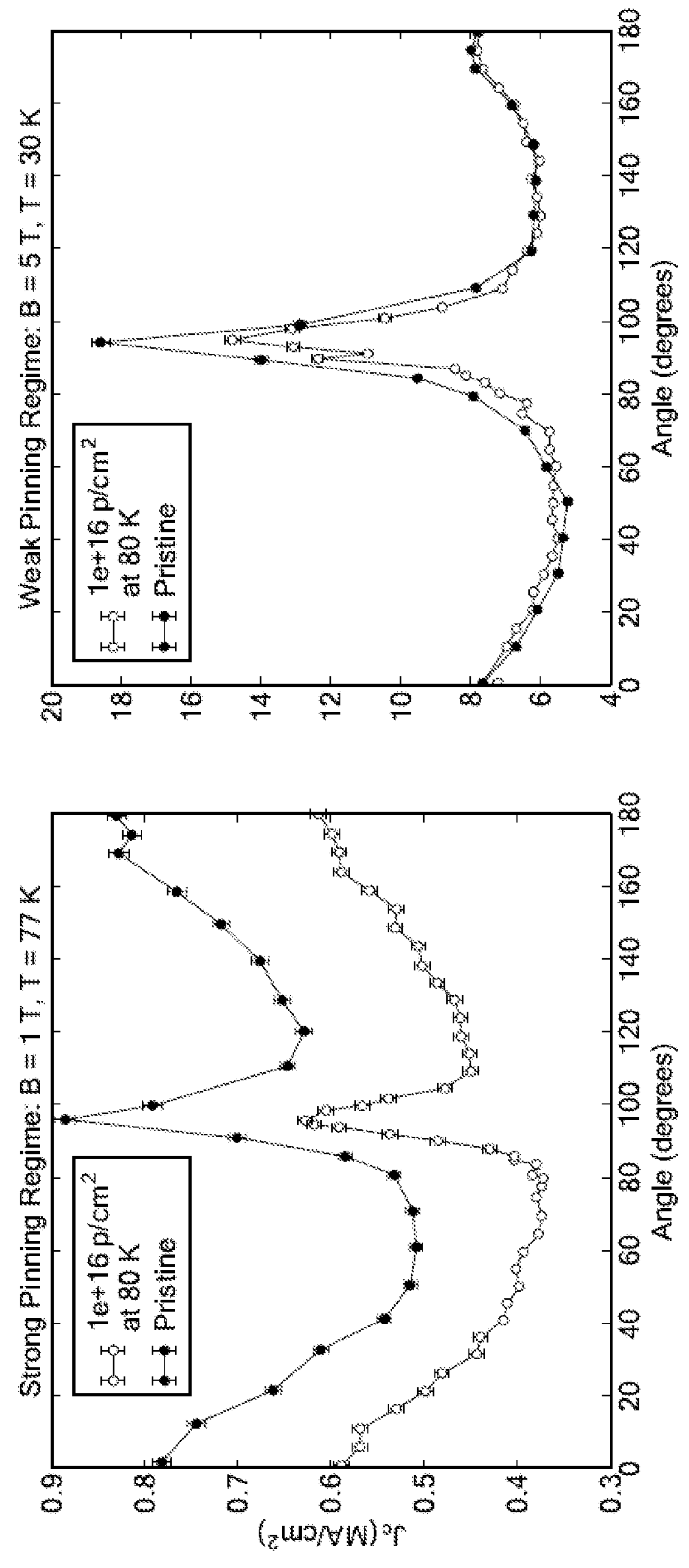
Strong Pinning Regime: B = 1 T, T = 77 K
1e+16 p/cm^2
at 80 K
Pristine
Jc (MA/cm²)
Angle (degrees)
Weak Pinning Regime: B = 5 T, T = 30 K
1e+16 p/cm^2
at 80 K
Pristine
Angle (degrees)

*FIG. 10B*

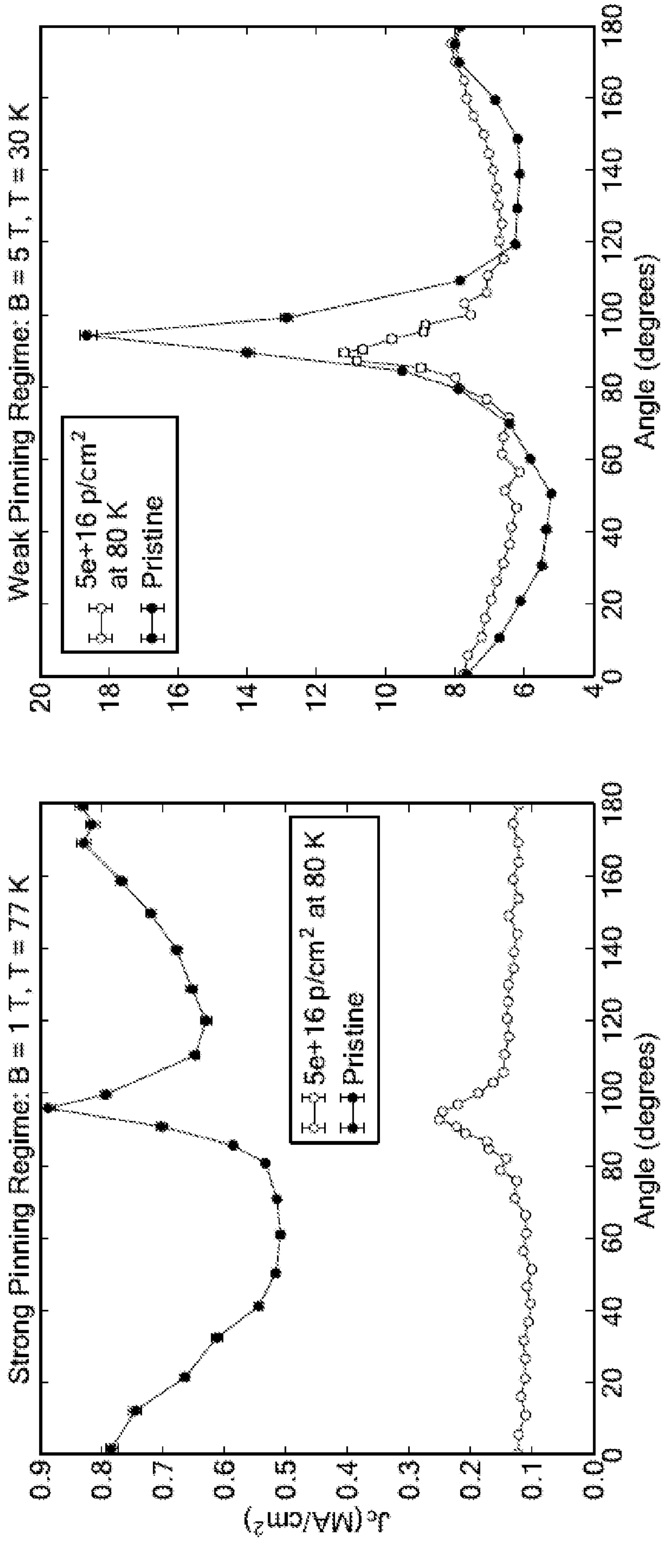
Strong Pinning Regime: B = 1 T, T = 77 K
5e+16 p/cm2 at 80 K
Pristine
Jc (MA/cm2)
Angle (degrees)
Weak Pinning Regime: B = 5 T, T = 30 K
5e+16 p/cm2
at 80 K
Pristine
Angle (degrees)

*FIG. 10C*

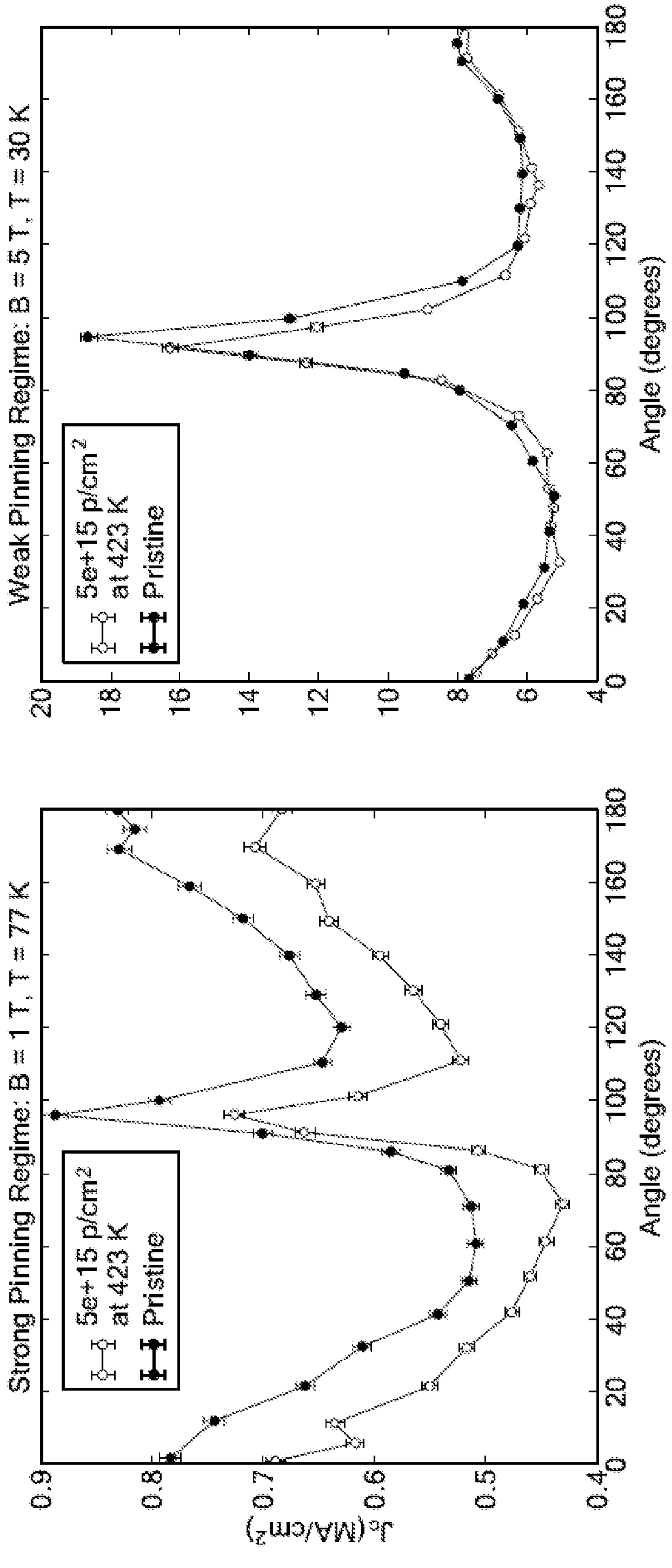
Strong Pinning Regime: B = 1 T, T = 77 K
5e+15 p/cm2
at 423 K
Pristine
Jc (MA/cm2)
Angle (degrees)
Weak Pinning Regime: B = 5 T, T = 30 K
5e+15 p/cm2
at 423 K
Pristine
Angle (degrees)

FIG. 10D

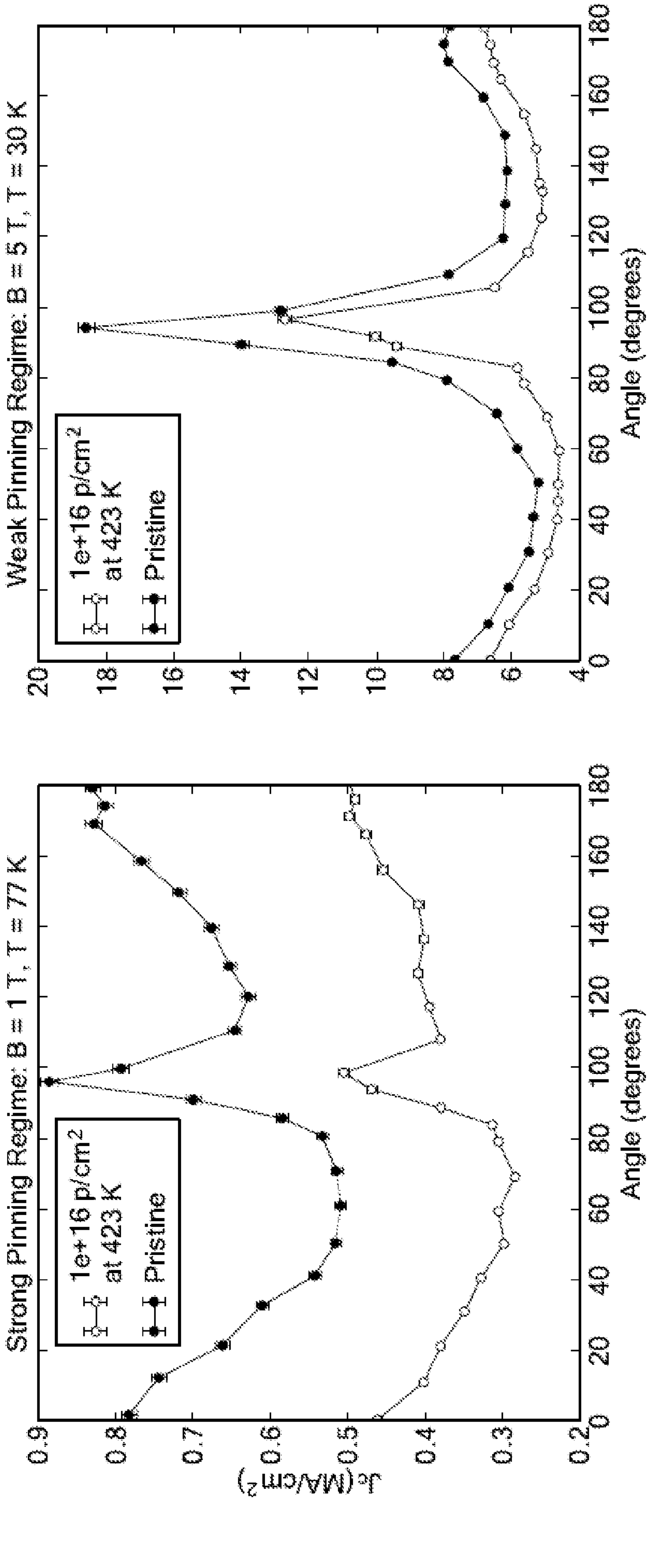
Strong Pinning Regime: B = 1 T, T = 77 K
1e+16 p/cm$^2$ at 423 K
Pristine
$J_c$(MA/cm$^2$)
Angle (degrees)
Weak Pinning Regime: B = 5 T, T = 30 K
1e+16 p/cm$^2$ at 423 K
Pristine
Angle (degrees)

*FIG. 10E*

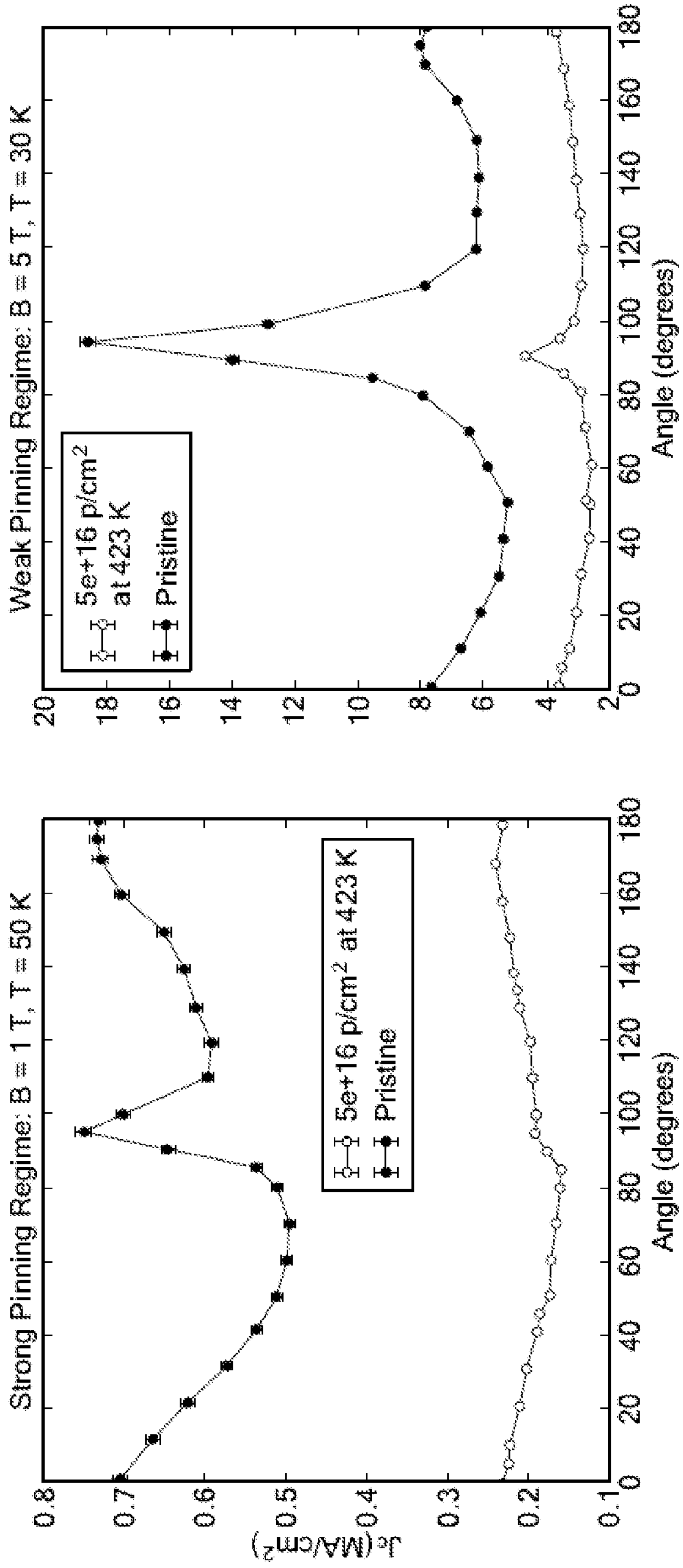

Strong Pinning Regime: B = 1 T, T = 50 K
Weak Pinning Regime: B = 5 T, T = 30 K
5e+16 p/cm$^2$ at 423 K
Pristine
5e+16 p/cm$^2$
at 423 K
Pristine
$J_c$ (MA/cm$^2$)
Angle (degrees)
Angle (degrees)
0.1
0.2
0.3
0.4
0.5
0.6
0.7
0.8
2
4
6
8
10
12
14
16
18
20
0
20
40
60
80
100
120
140
160
180


*FIG. 10F*

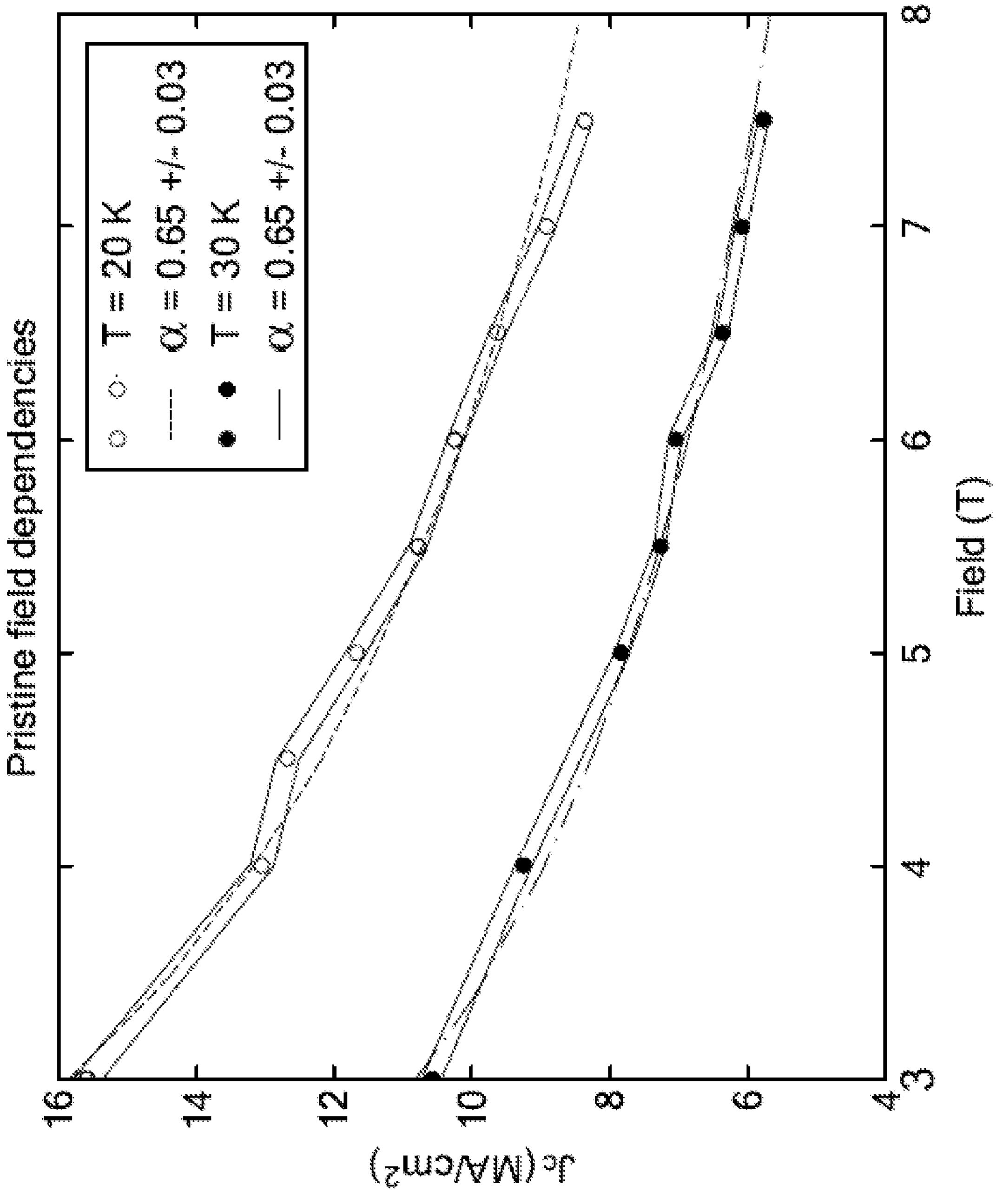
Pristine field dependencies
T = 20 K
α = 0.65 +/- 0.03
T = 30 K
α = 0.65 +/- 0.03
Jc (MA/cm²)
Field (T)
16
14
12
10
8
6
4
3
4
5
6
7
8

*FIG. 11A*

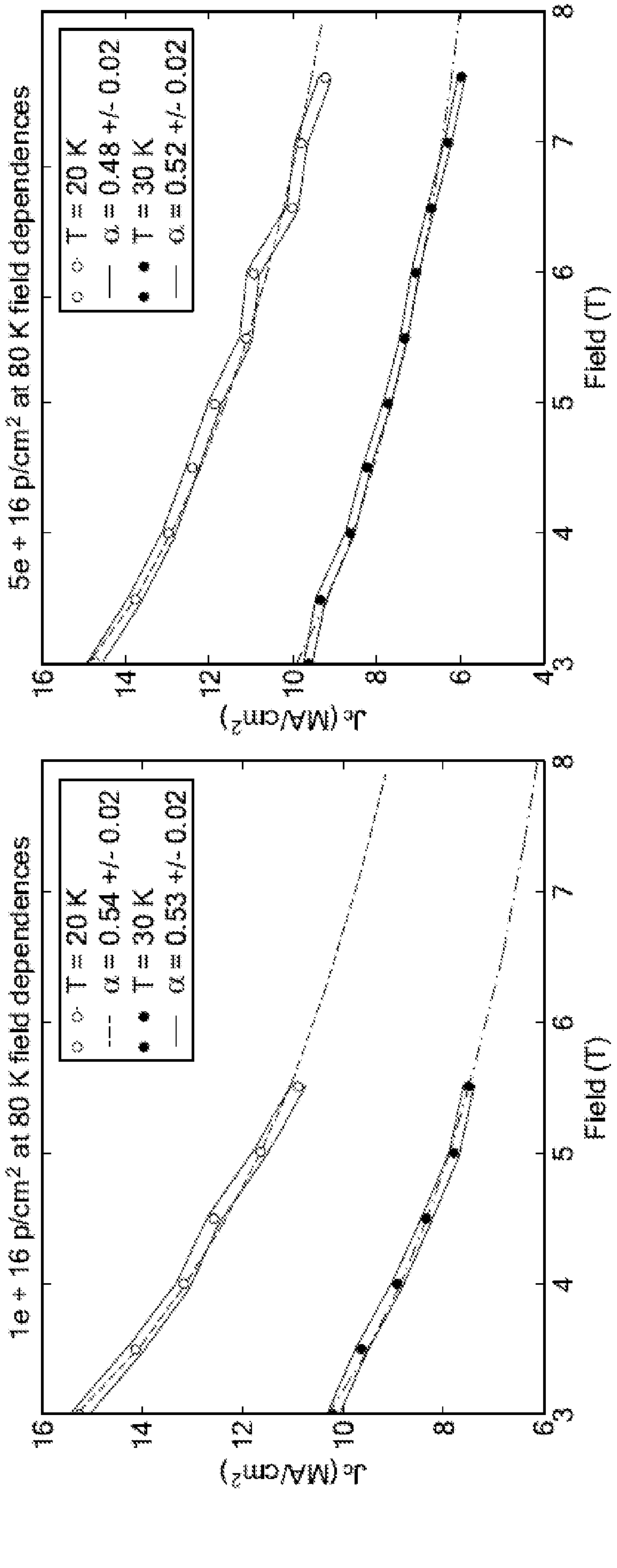
5e + 16 p/cm² at 80 K field dependences
T = 20 K
α = 0.48 +/- 0.02
T = 30 K
α = 0.52 +/- 0.02
Jc (MA/cm²)
Field (T)
16
14
12
10
8
6
4
3
4
5
6
7
8
1e + 16 p/cm² at 80 K field dependences
T = 20 K
α = 0.54 +/- 0.02
T = 30 K
α = 0.53 +/- 0.02
Jc (MA/cm²)
Field (T)
16
14
12
10
8
6
3
4
5
6
7
8

*FIG. 11B*

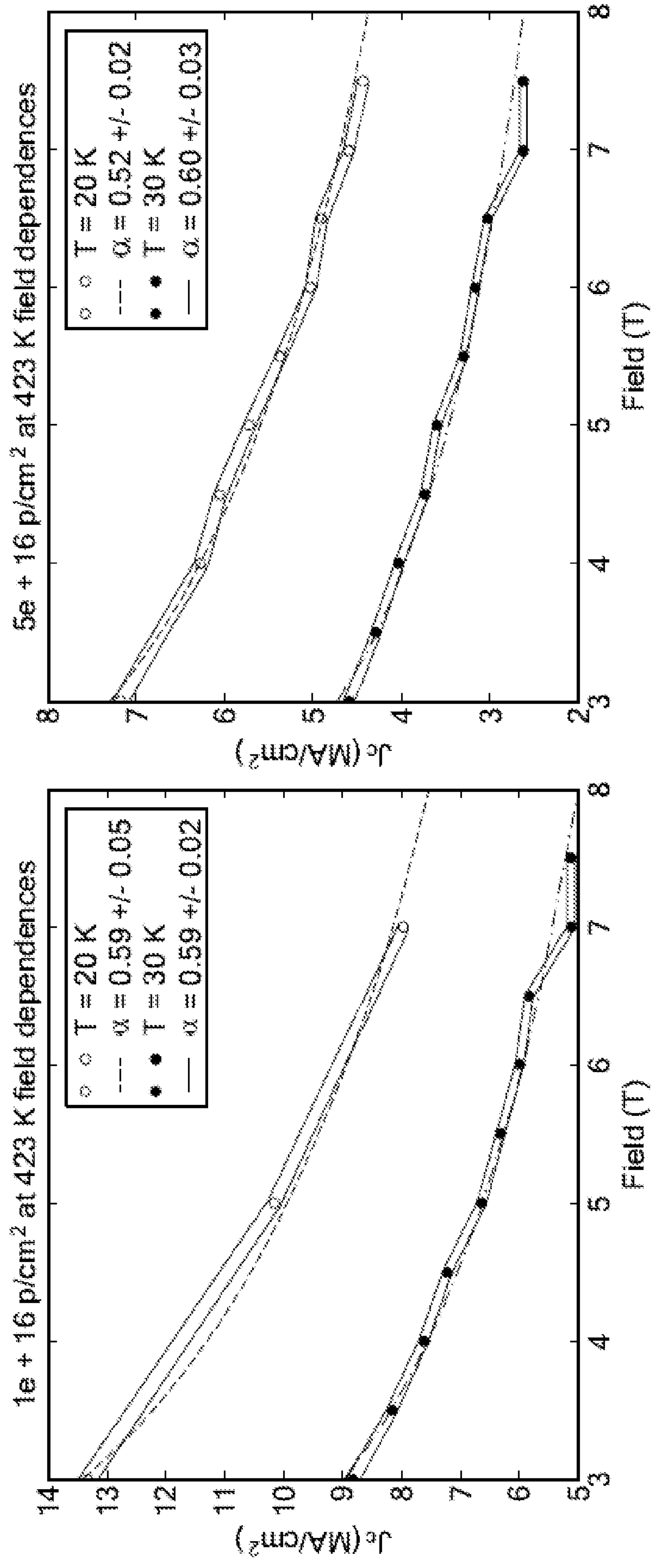
5e + 16 p/cm² at 423 K field dependences
T = 20 K
α = 0.52 +/- 0.02
T = 30 K
α = 0.60 +/- 0.03
Jc (MA/cm²)
Field (T)
1e + 16 p/cm² at 423 K field dependences
T = 20 K
α = 0.59 +/- 0.05
T = 30 K
α = 0.59 +/- 0.02
Jc (MA/cm²)
Field (T)

*FIG. 11C*

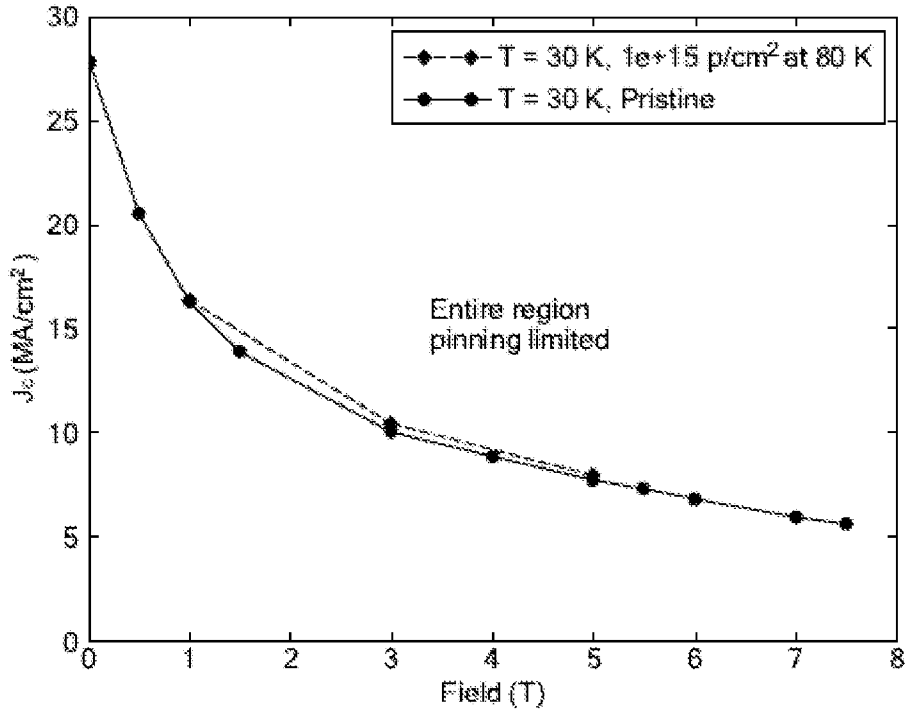


*FIG. 12A*

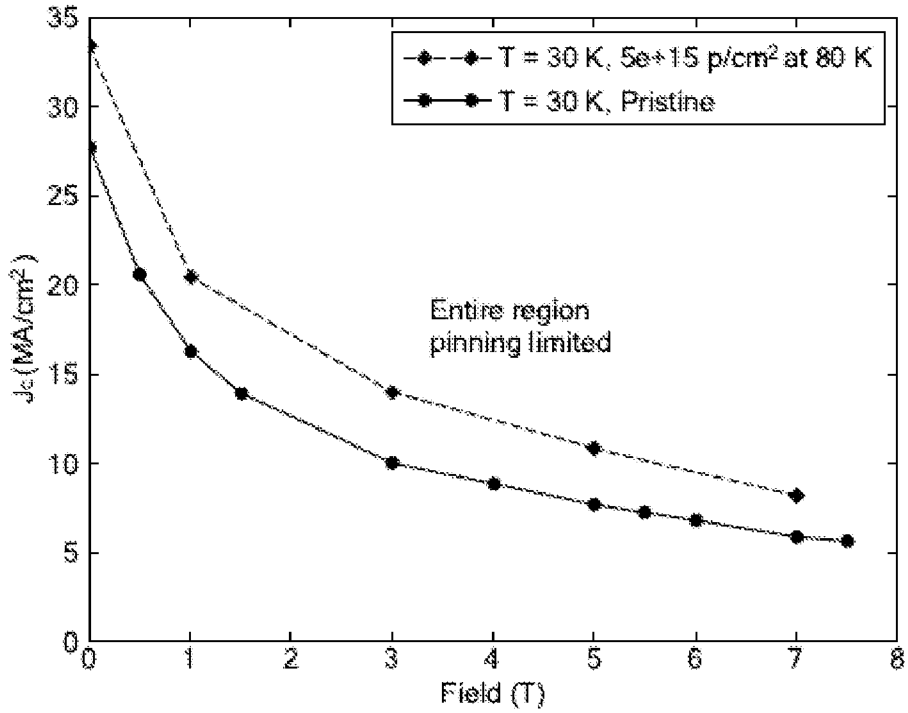


*FIG. 12B*

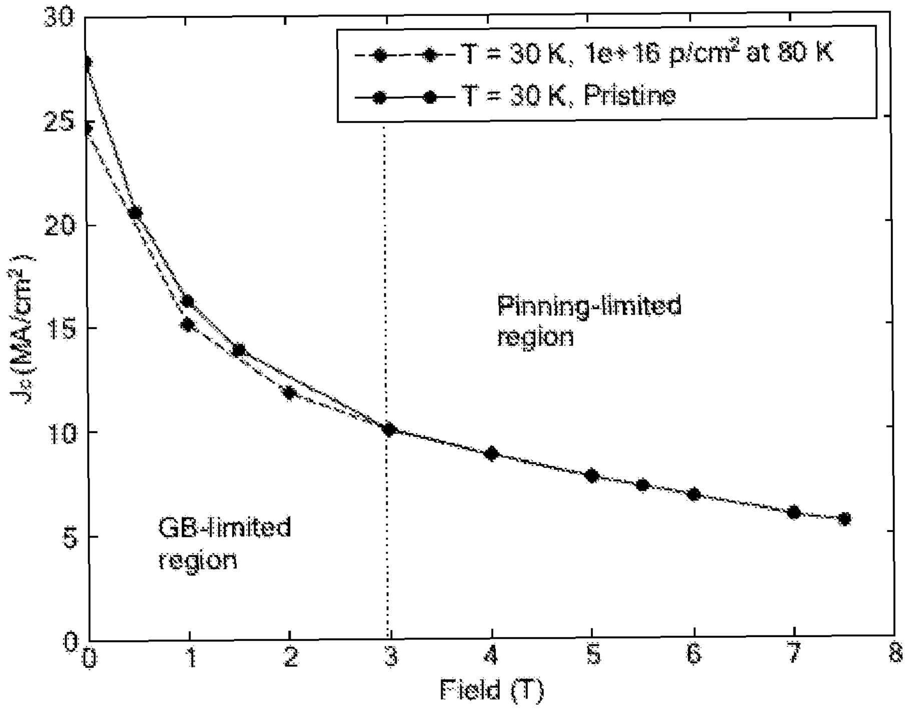


FIG. 12C

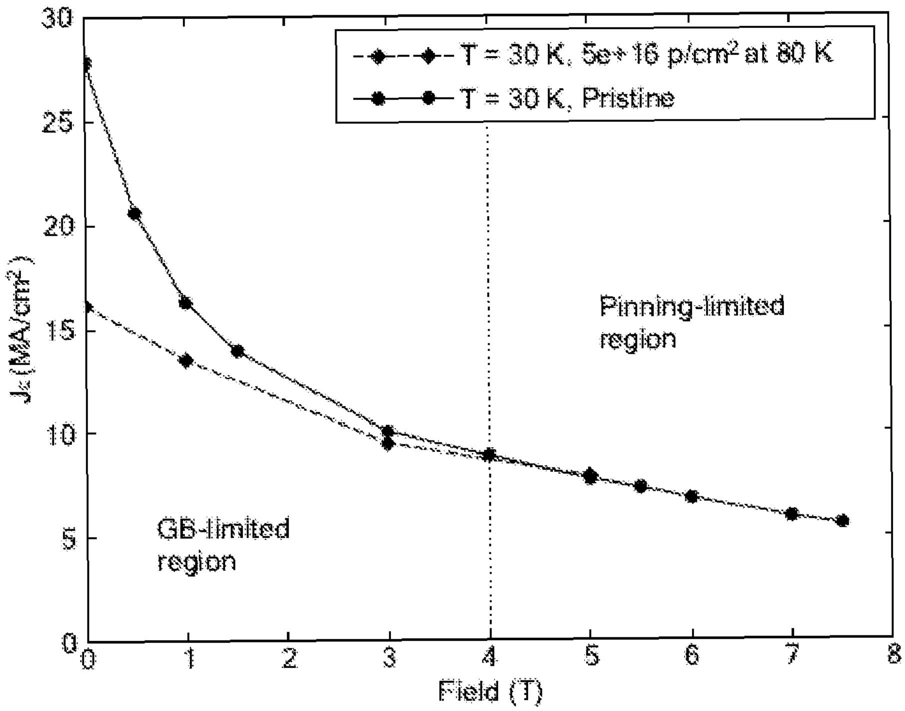


FIG. 12D

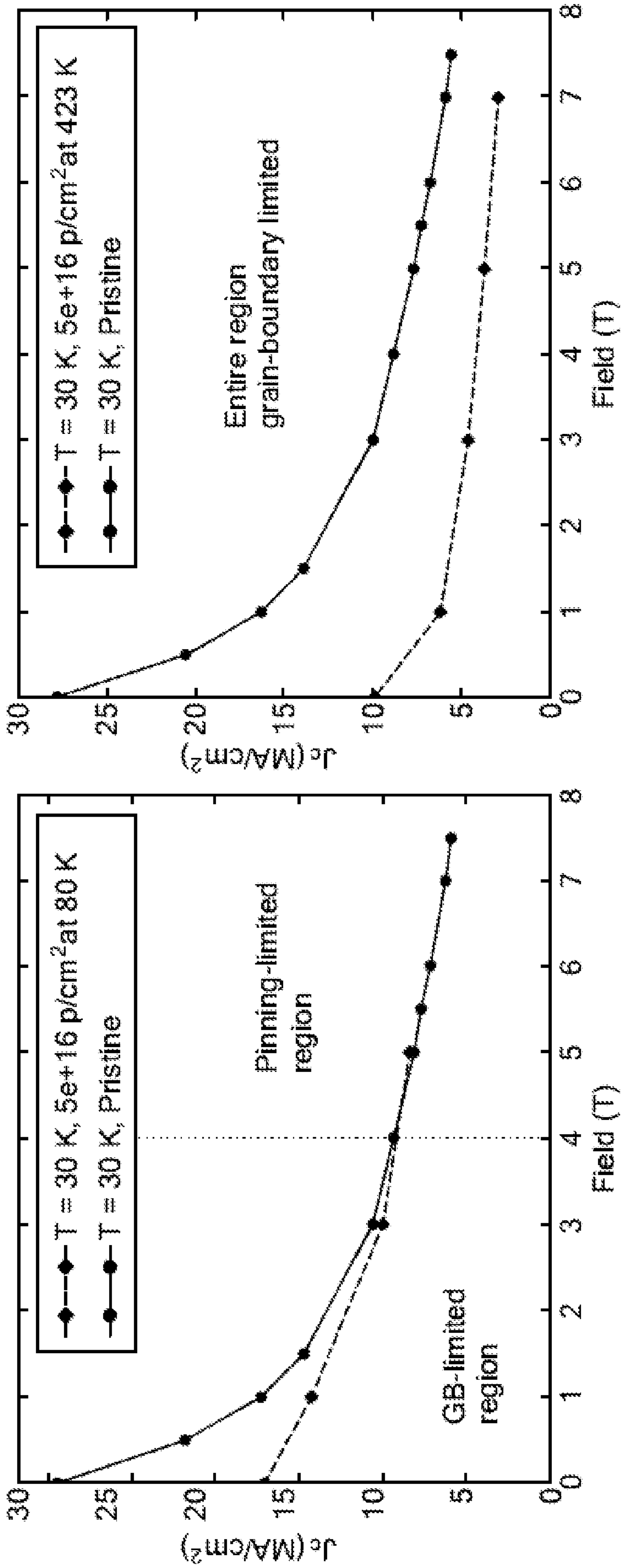
T = 30 K, 5e+16 p/cm2 at 423 K
T = 30 K, Pristine
Entire region
grain-boundary limited
Field (T)
Jc (MA/cm2)
T = 30 K, 5e+16 p/cm2 at 80 K
T = 30 K, Pristine
Pinning-limited
region
GB-limited
region
Field (T)
Jc (MA/cm2)

*FIG. 13*

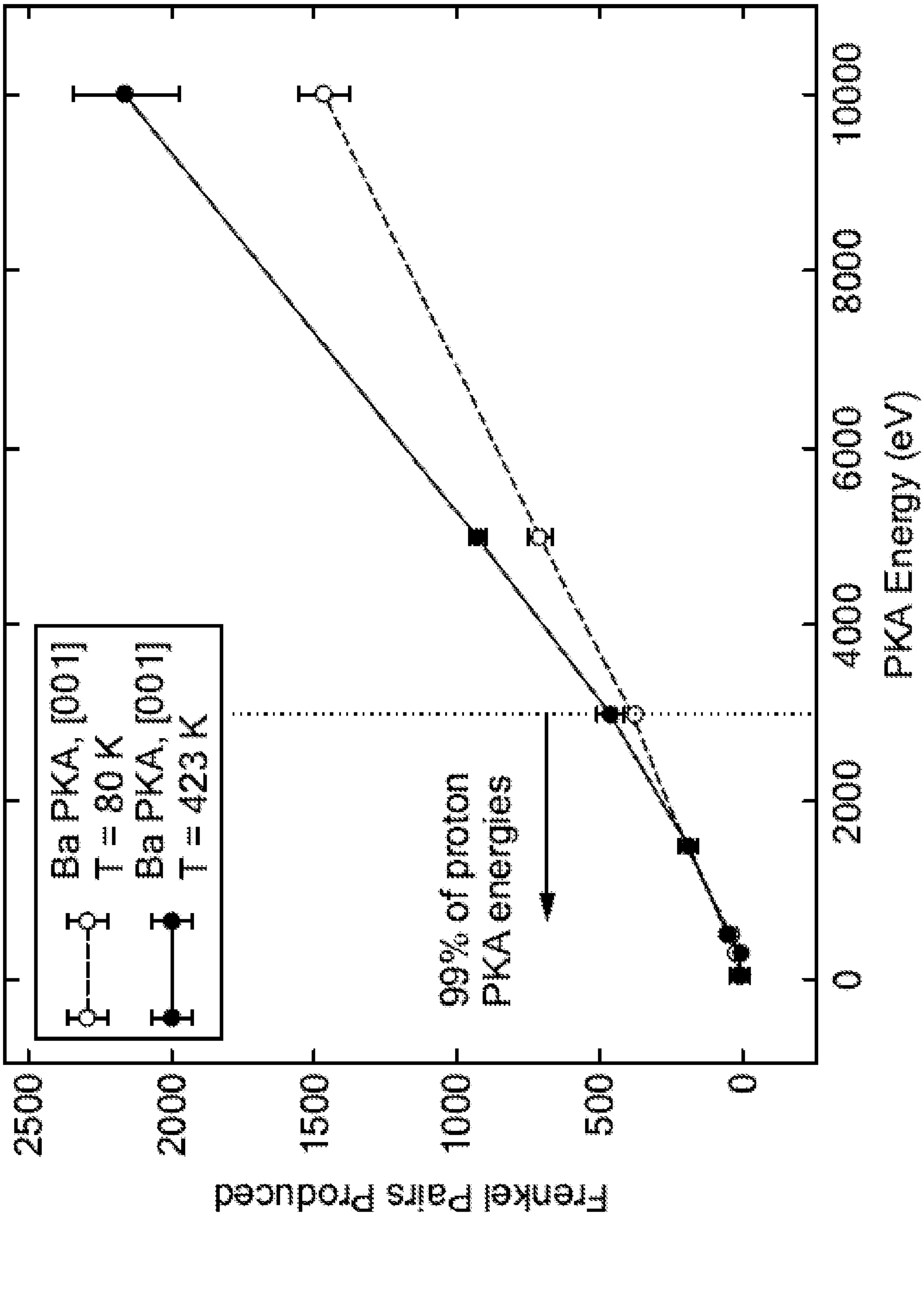
Ba PKA, [001]
T = 80 K
Ba PKA, [001]
T = 423 K
99% of proton
PKA energies
Frenkel Pairs Produced
PKA Energy (eV)
0
500
1000
1500
2000
2500
0
2000
4000
6000
8000
10000

*FIG. 14*

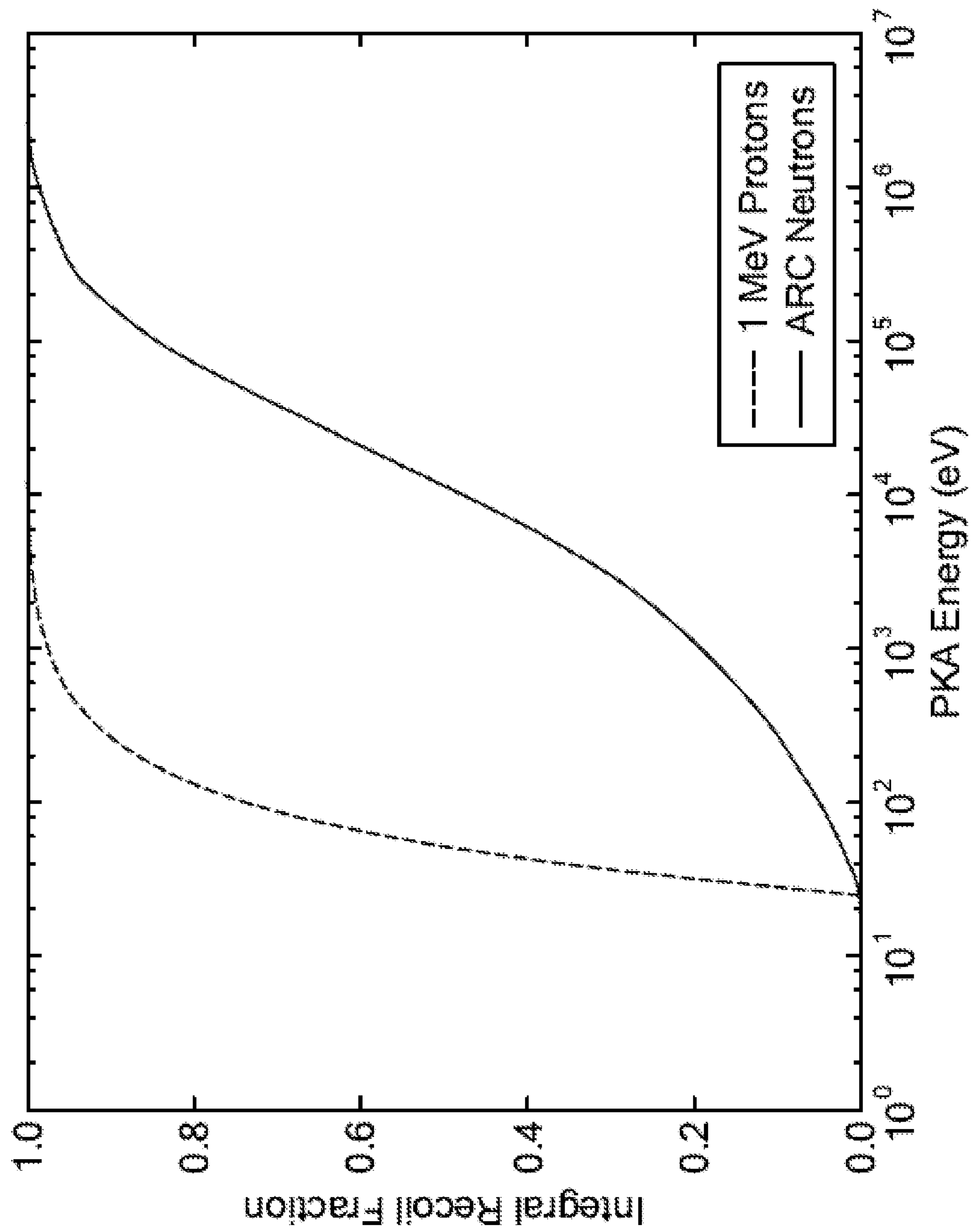
1.0
0.8
0.6
0.4
0.2
0.0
Integral Recoil Fraction
$10^0$
$10^1$
$10^2$
$10^3$
$10^4$
$10^5$
$10^6$
$10^7$
PKA Energy (eV)
1 MeV Protons
ARC Neutrons

*FIG. 15*

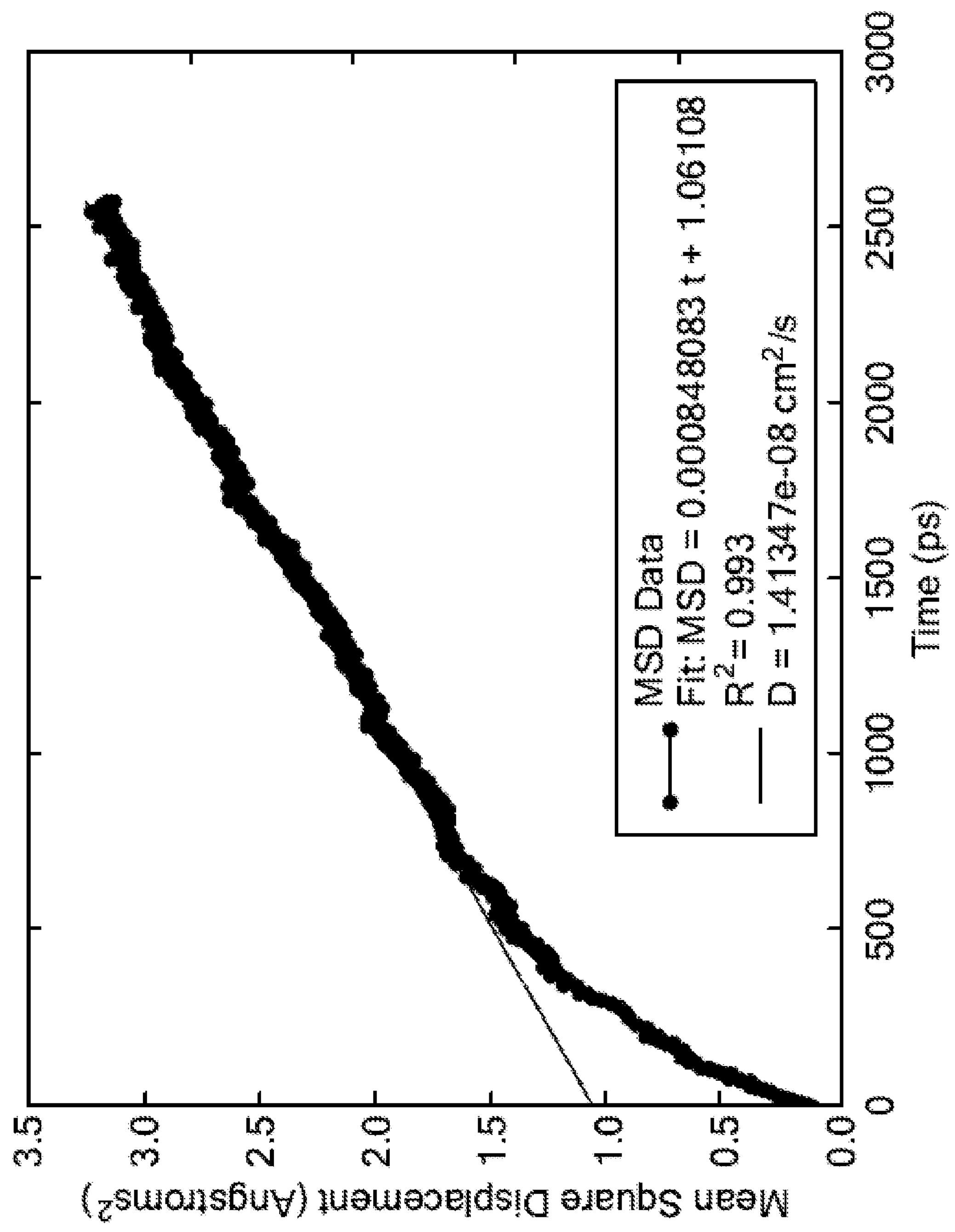
MSD Data
Fit: MSD = 0.000848083 t + 1.06108
$R^2$ = 0.993
D = 1.41347e-08 $cm^2$/s
Time (ps)
Mean Square Displacement (Angstroms²)
0
500
1000
1500
2000
2500
3000
0.0
0.5
1.0
1.5
2.0
2.5
3.0
3.5

*FIG. 16*

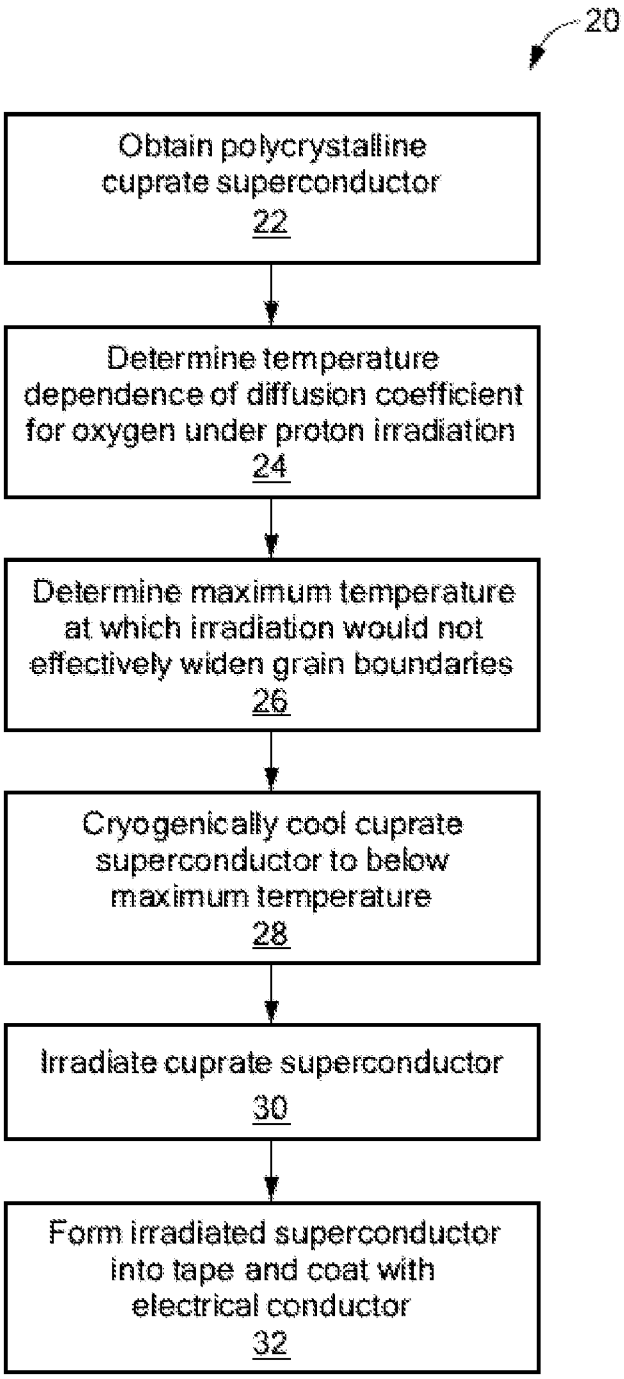
20
Obtain polycrystalline cuprate superconductor
22
Determine temperature dependence of diffusion coefficient for oxygen under proton irradiation
24
Determine maximum temperature at which irradiation would not effectively widen grain boundaries
26
Cryogenically cool cuprate superconductor to below maximum temperature
28
Irradiate cuprate superconductor
30
Form irradiated superconductor into tape and coat with electrical conductor
32

*FIG. 17*

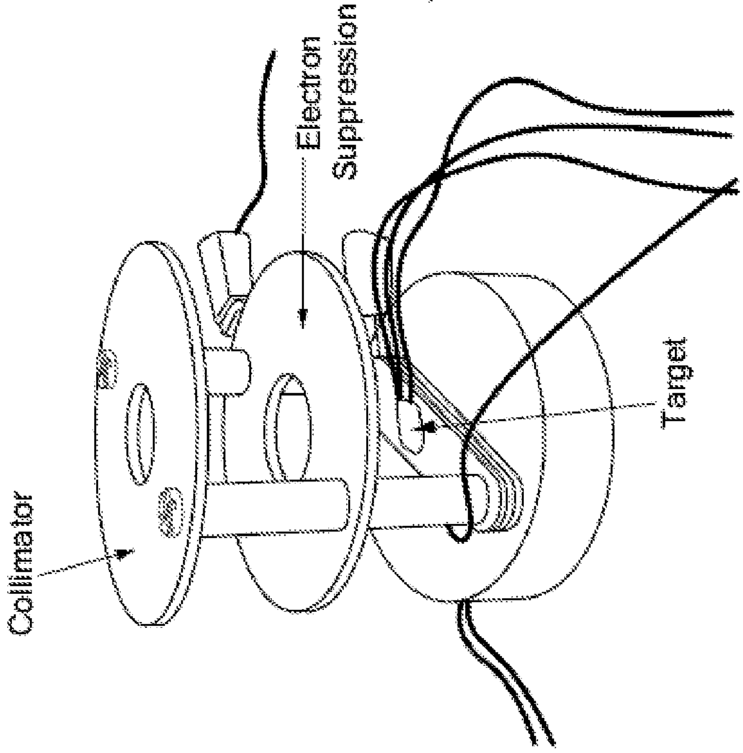


FIG. 18A

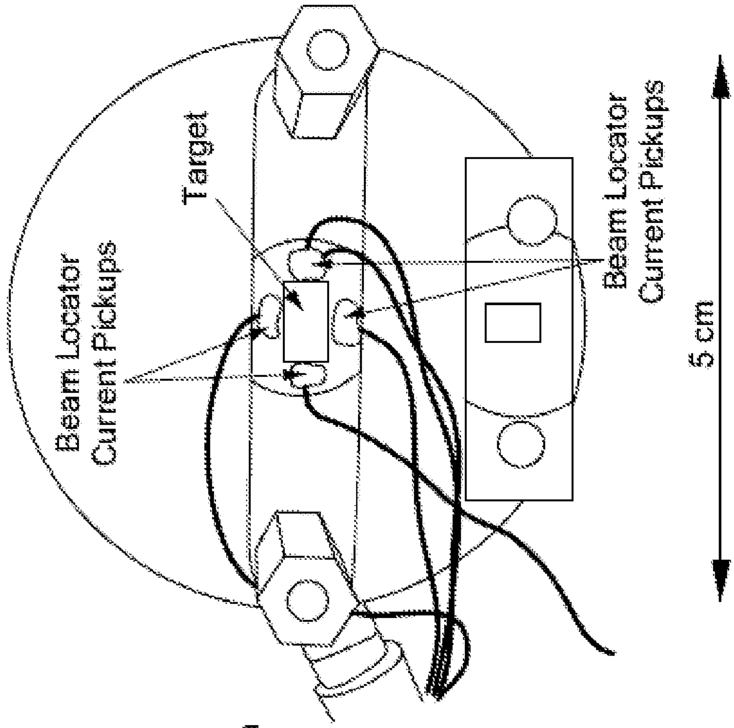


FIG. 18B

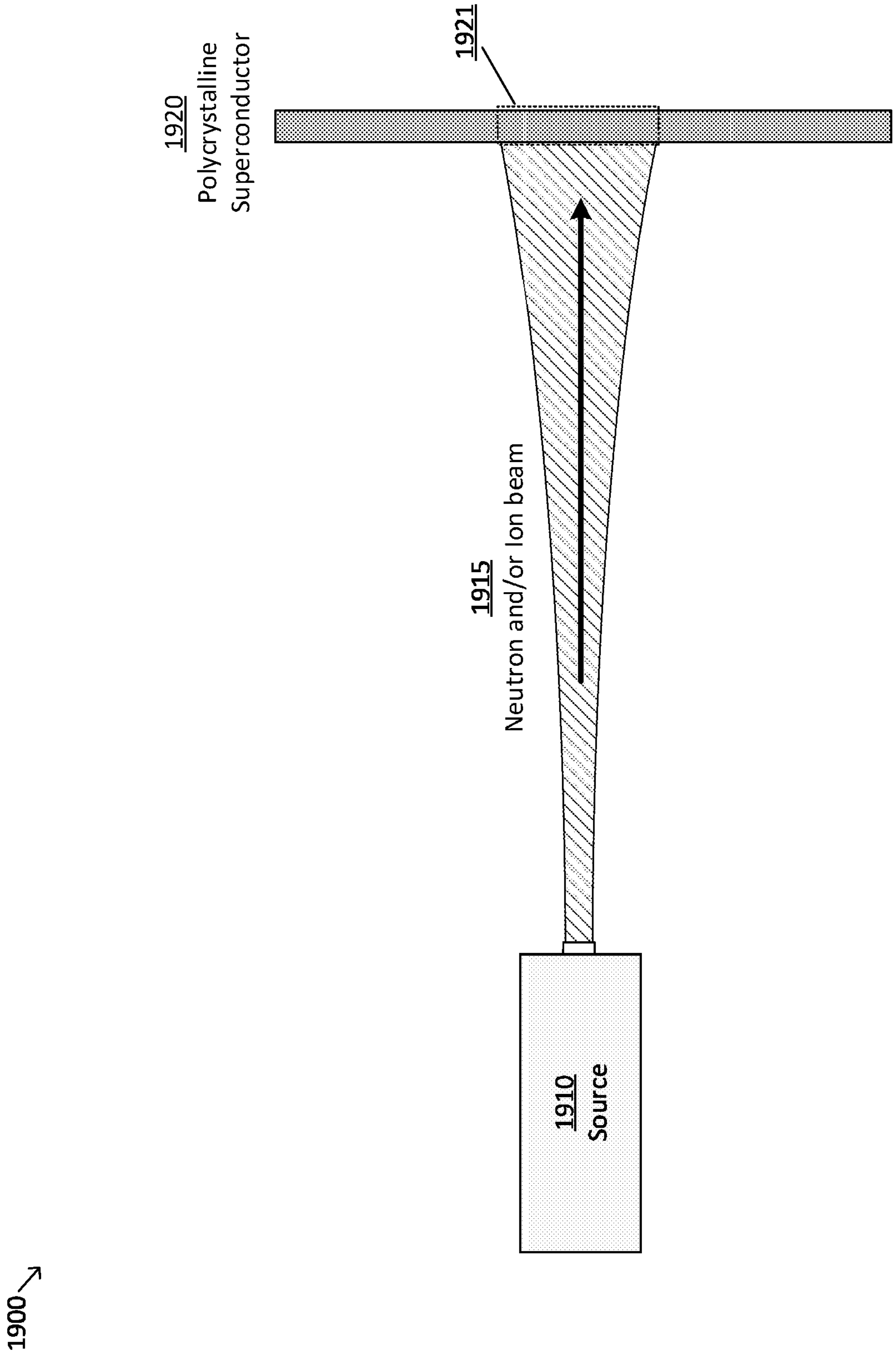
1900
1920
Polycrystalline
Superconductor
1921
1915
Neutron and/or Ion beam
1910
Source

FIG. 19

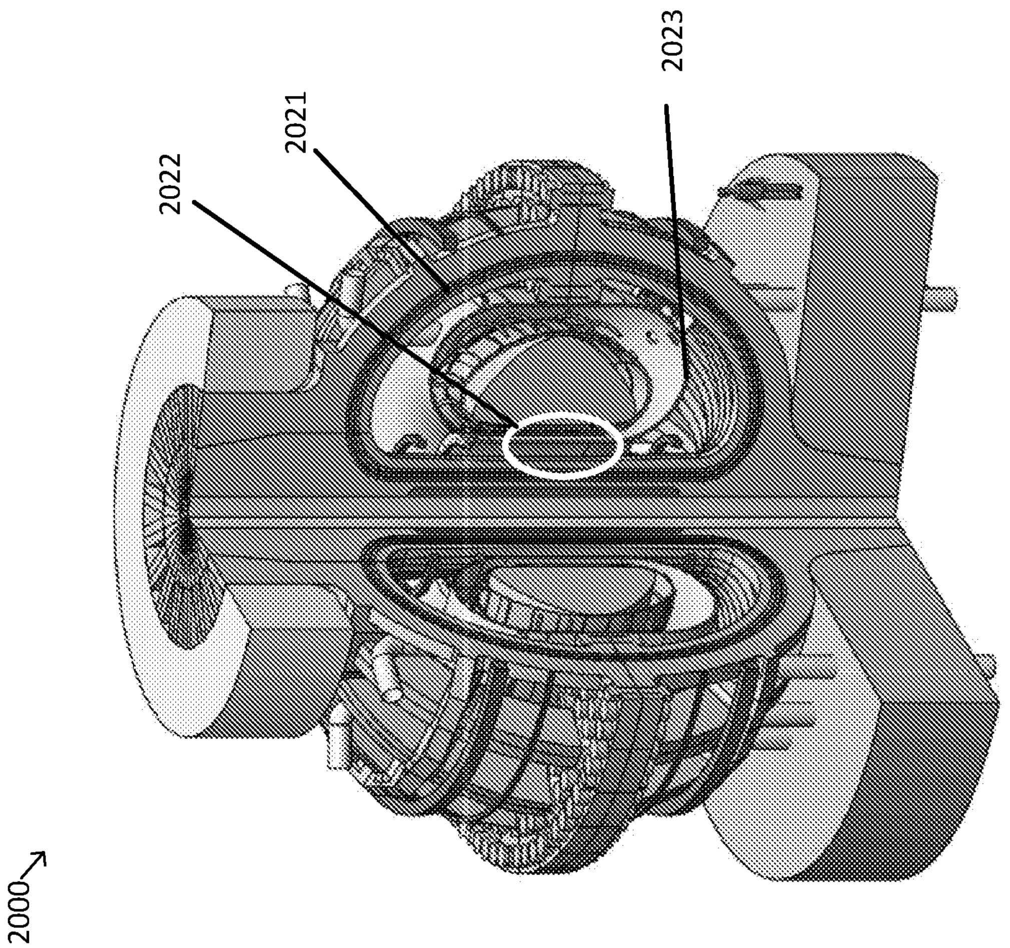


FIG. 20B

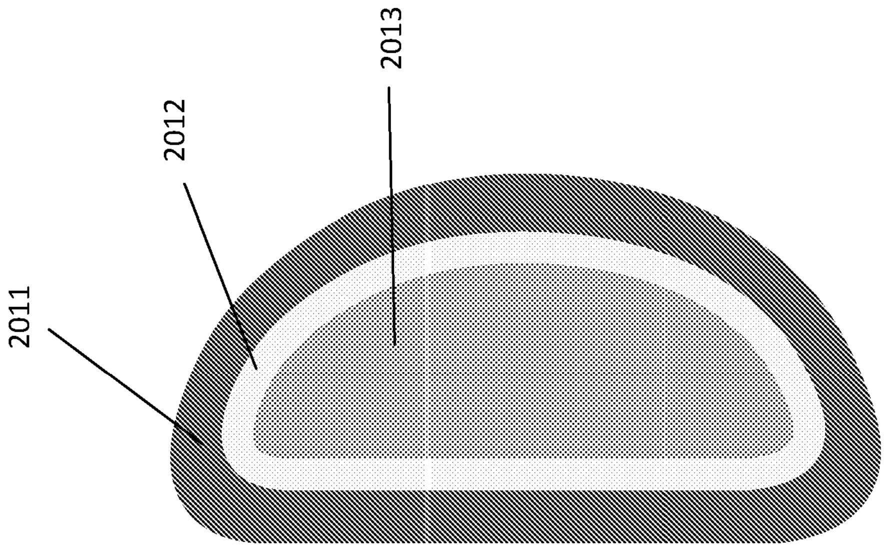


FIG. 20A

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Irradiation-induced inter- and intra-granular modifications by 120 MeV S ions in YBa2Cu3O7 thick films. **BEHERA D et al.** MODERN PHYSICS LETTERS B: CONDENSED MATTER PHYSICS; STATISTICAL PHYSICS AND APPLIED PHYSICS. WORLD SCIENTIFIC PUBLISHING CO. PTE. LTD, 30 January 2001, vol. 15, 69-80
- **PROKOPEC R et al.** Suitability of coated conductors for fusion magnets in view of their radiation response. *SUPERCONDUCTOR SCIENCE AND TECHNOLOGY*, 2015, vol. 28 (014005), 1-8
- **TORU AOKI et al.** Effect of Neutron Irradiation on High-Temperature Superconductors. *IEEE TRANSACTIONS ON SUPERCONDUCTIVITY*, 2011, vol. 21 (3), 3200-3202